# EUROPEAN PATENT SPECIFICATION

(11) **EP 4 243 438 B1**
(45) Date of publication and mention of the grant of the patent: **24.09.2025**
(21) Application number: 23161119.5
(22) Date of filing: 10.03.2023
(51) Int. Cl.: H04Q 9/00, G01R 31/392

(54) **BATTERY FAULT DIAGNOSIS METHOD AND APPARATUS**
VERFAHREN UND VORRICHTUNG ZUR BATTERIEFEHLERDIAGNOSE
PROCÉDÉ ET APPAREIL DE DIAGNOSTIC DE DÉFAILLANCE DE BATTERIE

(30) Priority: 11.03.2022 CN 202210242950
(43) Date of publication of application: 13.09.2023
(73) Proprietor: Huawei Digital Power Technologies Co., Ltd., Shenzhen, 518043 (CN)
(72) Inventor: DU, Ruoyang, Shenzhen, 518043 (CN); REN, Huizi, Shenzhen, 518043 (CN); HE, Tao, Shenzhen, 518043 (CN); SUN, Yuanjun, Shenzhen, 518043 (CN); XIA, Dezhou, Shenzhen, 518043 (CN)
(74) Representative: Körber, Martin Hans

(56) References cited:
- WO-A1-2019/184848
- CN-A- 114 137 428

## Description

### TECHNICAL FIELD

This application relates to the field of new energy vehicles, and in particular to a battery fault diagnosis method and apparatus.

### BACKGROUND

With wide application of electric vehicles, more attention is paid to fault diagnosis of power batteries. Battery faults greatly affect running of vehicles, and even bring personal and property safety risks. Therefore, real-time faults of batteries need to be predicted and diagnosed, and then the batteries are controlled based on diagnostic results, thereby reducing a serious consequence that may be caused by the faults, and improving safety.

Currently, battery faults are diagnosed mainly based on industry standards, such as GB/T 32960. Data is collected from a vehicle battery management system (BMS) and fault diagnosis is performed based on the collected data. However, data collected from the BMS is limited, and fault diagnosis performed based thereon may have a specific error. A battery troubleshooting solution may be improper, and this may cause a safety risk, a waste of resources, or the like.

Therefore, it is expected that a method can be provided to improve battery fault diagnosis accuracy.

CN 114 137 428 A discloses a portable power battery safety detection system and detection device. WO 2019/184848 discloses an electric vehicle and a prompt system that comprises a cloud server, a client, and a BMS disposed on an electric vehicle.

### SUMMARY

Embodiments of this application provide a battery fault diagnosis method and apparatus, to improve battery fault diagnosis accuracy. The invention is defined in the independent claims. Additional features of the invention are provided in the dependent claims. In the following, parts of the description and drawings referring to embodiments which are not covered by the claims are not presented as embodiments of the invention, but as examples useful for understanding the invention.

According to a first aspect, this application provides a battery fault diagnosis method. The method may be performed by a cloud BMS.

For example, the method includes: receiving a first original data set from a vehicle, where the first original data set is obtained from the vehicle through collection; preliminarily diagnosing a battery of the vehicle based on the first original data set, and sending a risk warning to the vehicle based on the preliminary diagnosis for the battery; and receiving data from the vehicle, where the data includes a second original data set, or first diagnostic data obtained by the vehicle based on the second original data set, the second original data set is obtained from the vehicle through collection, the second original data set is used to deeply diagnose the battery, and data items included in the second original data set are more than data items included in the first original data set or a data collection frequency of the second original data set is higher than a data collection frequency of the first original data set.

The data from the vehicle may include a part or all of data in the second original data set, or first diagnostic data, or a part or all of data in the first diagnostic data and the second original data set.

The data items included in the second original data set are more than the data items included in the first original data set or the data collection frequency of the second original data set is higher than the data collection frequency of the first original data set. Alternatively, the data items included in the second original data set are more than the data items included in the first original data set and the data collection frequency of the second original data set is higher than the data collection frequency of the first original data set.

Based on the foregoing solution, the cloud BMS may first preliminarily diagnose the battery based on the first original data set. When it is predicted that the battery has a relatively high risk, the cloud BMS may send a risk warning to the vehicle, to obtain the second original data set for deeply diagnosing the battery. Based on the deep diagnosis, the data items included in the second original data set are more than the data items included in the first original data set or the data collection frequency of the second original data set is higher than the data collection frequency of the first original data set. Alternatively, the data items included in the second original data set are more than the data items included in the first original data set and the data collection frequency of the second original data set is higher than the data collection frequency of the first original data set. That is, the deep diagnosis is based on more abundant and comprehensive data, whereby the battery may be more deeply diagnosed, thereby helping obtain a more accurate diagnostic result and improving battery fault diagnosis accuracy.

With reference to the first aspect, in some possible implementations of the first aspect, the method includes: deeply diagnosing the battery based on the second original data set, to determine a fault level of the battery.

In other words, the data from the vehicle includes the second original data set, for example, may be a part or all of data in the second original data set. This is not limited in this application. The cloud BMS may deeply diagnose the battery based on the data in the second original data set.

Because data included in the second original data set is more abundant and comprehensive than data included in the first original data set and the second original data set includes data that is more closely related to a battery fault, the cloud BMS deeply diagnoses the battery based on the data, thereby more accurately determining a fault level of the battery.

With reference to the first aspect, in some possible implementations of the first aspect, the method includes: deeply diagnosing the battery based on the second original data set and the first diagnostic data, to determine a fault level of the battery.

In other words, the data from the vehicle includes the second original data set and the first diagnostic data. A part or all of data in the second original data set may be uploaded to the cloud BMS. The first diagnostic data may include, for example, data obtained through deep diagnosis based on a part or all of data in the second original data set, which may be, for example, an eigenvalue extracted through feature engineering. The first diagnostic data is uploaded to the cloud BMS, in order that the cloud BMS may perform further deep diagnosis, thereby determining a fault level of the battery.

Because data included in the second original data set is more abundant and comprehensive than data included in the first original data set and the second original data set includes data that is more closely related to a battery fault, the cloud BMS deeply diagnoses the battery based on the data in the second original data set to obtain second diagnostic data, and then determines a fault level of the battery based on the second diagnostic data and the first diagnostic data from the vehicle. That is, the cloud BMS cooperates with the vehicle to deeply diagnose the battery based on the data in the second original data set, thereby more accurately determining a fault level of the battery.

With reference to the first aspect, in some possible implementations of the first aspect, the first diagnostic data includes a fault level of the battery.

In other words, the vehicle may deeply diagnose the battery based on the second original data set, to determine a fault level of the battery. In this case, the vehicle may directly upload the fault level of the battery to the cloud BMS, without a need of the cloud BMS for deep diagnosis.

Because data included in the second original data set is more abundant and comprehensive than data included in the first original data set and the second original data set includes data that is more closely related to a battery fault, the vehicle deeply diagnoses the battery based on the data in the second original data set to obtain the first diagnostic data that includes the fault level of the battery. The cloud BMS may obtain the fault level of the battery from the vehicle, thereby reducing the computing resource consumption of the cloud BMS.

With reference to the first aspect, in some possible implementations of the first aspect, the sending a risk warning to the vehicle based on the preliminary diagnosis for the battery includes: determining a diagnostic result based on the preliminary diagnosis for the battery, where the diagnostic result includes a state of health of the battery or a fault probability value of the battery, and sending the risk warning to the vehicle when the diagnostic result reaches a preset threshold.

If it is determined by preliminary diagnosis that there is a fault risk, the cloud BMS may send a risk warning to the vehicle, to remind a vehicle owner of the risk. In this way, when receiving the risk warning, the vehicle owner may transport the vehicle to a vehicle vendor for deep diagnosis, or perform operations such as battery replacement and maintenance, to reduce an accident occurrence rate.

With reference to the first aspect, in some possible implementations of the first aspect, when the diagnostic result reaches the preset threshold, the method further includes: sending an over-the-air technology (OTA) upgrade package to the vehicle, where the OTA upgrade package is used for an OTA upgrade of the vehicle.

Therefore, when it is predicted that the battery has a fault, the vehicle may control the battery in advance in an OTA upgrade manner, thereby avoiding further deterioration of the battery fault and reducing the accident occurrence rate.

Optionally, the OTA upgrade package includes a charge/discharge adjustment policy. The charge/discharge adjustment policy is used to adjust a maximum degree of charge and/or a maximum depth of discharge of the battery.

When the diagnostic result reaches the preset threshold, it may be determined that the battery may have a specific fault risk. When the battery may have a fault risk, an OTA upgrade package is sent to the vehicle, whereby the vehicle adjusts a maximum degree of charge and/or a maximum depth of discharge of the battery based on the OTA upgrade package, and controls the battery in advance, thereby avoiding further deterioration of the battery fault and reducing the accident occurrence rate. For example, a risk of spontaneous combustion or explosion caused by the fault in the battery may be reduced.

According to a second aspect, this application provides a battery fault diagnosis method. The method may be performed by a vehicle or a vehicle BMS.

For example, the method includes: uploading a first original data set obtained from the vehicle through collection to a cloud BMS, where the first original data set is used to preliminarily diagnose a battery of the vehicle, when a risk warning from the cloud BMS is received, obtaining a second original data set, where the second original data set is used to deeply diagnose the battery, where the risk warning is sent based on the preliminary diagnosis for the battery, the second original data set is obtained from the vehicle through collection, and data items included in the second original data set are more than data items included in the first original data set or a data collection frequency of the second original data set is higher than a data collection frequency of the first original data set; and sending data to the cloud BMS, where the data includes data in the second original data set, or first diagnostic data obtained by the vehicle based on the second original data set.

For description of the data from the vehicle and related content of the first original data set and the second original data set, refer to related descriptions in the first aspect. Details are not described herein again.

Based on the foregoing solution, a vehicle may first upload a collected first original data set to a cloud BMS, whereby the cloud BMS preliminarily diagnoses a battery based on the first original data set. When receiving a risk warning from the cloud BMS, the vehicle may collect a second original data set used for deep diagnosis. Based on the deep diagnosis, the data items included in the second original data set are more than the data items included in the first original data set or the data collection frequency of the second original data set is higher than the data collection frequency of the first original data set. Alternatively, the data items included in the second original data set are more than the data items included in the first original data set and the data collection frequency of the second original data set is higher than the data collection frequency of the first original data set. That is, the deep diagnosis is based on more abundant and comprehensive data, whereby the battery may be more deeply diagnosed, thereby helping obtain a more accurate diagnostic result and improving battery fault diagnosis accuracy.

With reference to the second aspect, in some possible implementations of the second aspect, the first diagnostic data includes a fault level of the battery, and the fault level is obtained through deep diagnosis performed by the vehicle based on the second original data set.

In other words, the vehicle may deeply diagnose the battery based on the second original data set, to determine a fault level of the battery. In this case, the vehicle may directly upload the fault level of the battery to the cloud BMS, without a need of the cloud BMS for deep diagnosis.

Because data included in the second original data set is more abundant and comprehensive than data included in the first original data set and the second original data set includes data that is more closely related to a battery fault, the vehicle may deeply diagnose the battery based on the data in the second original data set to obtain first diagnostic data that includes a fault level of the battery, and upload the fault level of the battery to the cloud BMS, thereby reducing the computing resource consumption of the cloud BMS.

With reference to the second aspect, in some possible implementations of the second aspect, the sending data to the cloud BMS includes: sending the second original data set and the first diagnostic data to the cloud BMS, where the second original data set and the first diagnostic data are used by the cloud BMS to deeply diagnose the battery, to determine a fault level of the battery.

In other words, the data from the vehicle includes the second original data set and the first diagnostic data. A part or all of data in the second original data set may be uploaded to the cloud BMS. The first diagnostic data may include, for example, data obtained through deep diagnosis based on a part or all of data in the second original data set, which may be, for example, an eigenvalue extracted through feature engineering. The first diagnostic data is uploaded to the cloud BMS, in order that the cloud BMS may perform further deep diagnosis, thereby determining a fault level of the battery.

After the data obtained by the vehicle by performing deep diagnosis based on the second original data set is uploaded to the cloud BMS, the cloud BMS may deeply diagnose the battery. That is, the vehicle assists the cloud BMS in deeply diagnosing the battery, thereby reducing the computing resource consumption of the cloud BMS. Because data included in the second original data set is more abundant and comprehensive than data included in the first original data set and the second original data set includes data that is more closely related to a battery fault, the battery is deeply diagnosed based on the data, thereby more accurately determining a fault level of the battery.

With reference to the second aspect, in some possible implementations of the second aspect, the sending data to the cloud BMS includes: uploading the second original data set to the cloud BMS, where the second original data set is used by the cloud BMS to deeply diagnose the battery, to determine a fault level of the battery.

In other words, the vehicle may directly upload the collected second original data set to the cloud BMS without processing the second original data set. The cloud BMS may deeply diagnose the battery based on the data in the second original data set. The vehicle may upload a part or all of data in the second original data set to the cloud BMS. This is not limited in this application.

The vehicle uploads the second original data set to the cloud BMS, to provide data support for the cloud BMS to deeply diagnose the battery. Because data included in the second original data set is more abundant and comprehensive than data included in the first original data set and the second original data set includes data that is more closely related to a battery fault, the cloud BMS deeply diagnoses the battery based on the data, thereby more accurately determining a fault level of the battery.

With reference to the second aspect, in some possible implementations of the second aspect, the method further includes: when a risk warning from the cloud BMS is received, performing an OTA upgrade based on an OTA upgrade package, where the OTA upgrade package comes from the cloud BMS or the vehicle.

Therefore, when it is predicted that the battery has a fault, the vehicle may control the battery in advance in an OTA upgrade manner, thereby avoiding further deterioration of the battery fault and reducing the accident occurrence rate.

Optionally, the OTA upgrade package includes a charge/discharge adjustment policy. The performing an OTA upgrade based on an OTA upgrade package includes: adjusting a maximum degree of charge and/or a maximum depth of discharge of the battery according to the charge/discharge adjustment policy.

When receiving the risk warning, the vehicle may determine that the battery may have a specific fault risk. The vehicle adjusts a maximum degree of charge and/or a maximum depth of discharge of the battery based on the OTA upgrade package from the cloud BMS, and controls the battery in advance, thereby avoiding further deterioration of the battery fault and reducing the accident occurrence rate. For example, a risk of spontaneous combustion or explosion caused by the fault in the battery may be reduced.

According to a third aspect, this application provides a battery fault diagnosis method. The method may be performed by a battery fault diagnosis system that includes a vehicle and a cloud BMS.

For example, the method includes: The vehicle uploads a collected first original data set to the cloud BMS. The cloud BMS preliminarily diagnoses a battery based on the first original data set and sends a risk warning to the vehicle based on the preliminary diagnosis for the battery. The vehicle obtains a second original data set based on the received risk warning. The risk warning is sent based on the diagnosis for the battery. The second original data set is obtained from the vehicle through collection, and data items included in the second original data set are more than data items included in the first original data set or a data collection frequency of the second original data set is higher than a data collection frequency of the first original data set. The vehicle and/or the cloud BMS deeply diagnose/diagnoses the battery based on the second original data set, to determine a fault level of the battery.

For description of the data from the vehicle and related content of the first original data set and the second original data set, refer to related descriptions in the first aspect. Details are not described herein again.

Based on the foregoing solution, a vehicle may first upload a collected first original data set to a cloud BMS, whereby the cloud BMS preliminarily diagnoses a battery based on the first original data set. When receiving a risk warning from the cloud BMS, the vehicle may collect a second original data set used for deep diagnosis. Based on the deep diagnosis, the data items included in the second original data set are more than the data items included in the first original data set or the data collection frequency of the second original data set is higher than the data collection frequency of the first original data set. Alternatively, the data items included in the second original data set are more than the data items included in the first original data set and the data collection frequency of the second original data set is higher than the data collection frequency of the first original data set. That is, the deep diagnosis is based on more abundant and comprehensive data, whereby the battery may be more deeply diagnosed, thereby helping obtain a more accurate diagnostic result and improving battery fault diagnosis accuracy.

With reference to the third aspect, in some possible implementations of the third aspect, the sending a risk warning to the vehicle based on the preliminary diagnosis for the battery includes: sending the risk warning to the vehicle when a state of health of the battery or a fault probability value of the battery reaches a preset threshold.

If it is determined by preliminary diagnosis that there is a fault risk, the cloud BMS may send a risk warning to the vehicle, to remind a vehicle owner of the risk. In this way, when receiving the risk warning, the vehicle owner may transport the vehicle to a vehicle vendor for deep diagnosis, or perform operations such as battery replacement and maintenance, to reduce an accident occurrence rate.

With reference to the third aspect, in some possible implementations of the third aspect, the method further includes: The vehicle uploads the second original data set to the cloud BMS. The vehicle and/or the cloud BMS deeply diagnose/diagnoses the battery based on the second original data set, to determine a fault level of the battery includes: The cloud BMS deeply diagnoses the battery based on the second original data set, to determine a fault level of the battery.

In other words, the vehicle may directly upload the collected second original data set to the cloud BMS without processing the second original data set. The cloud BMS may deeply diagnose the battery based on the data in the second original data set. The vehicle may upload a part or all of data in the second original data set to the cloud BMS. This is not limited in this application.

The vehicle uploads the second original data set to the cloud BMS, to provide data support for the cloud BMS to deeply diagnose the battery. Because data included in the second original data set is more abundant and comprehensive than data included in the first original data set and the second original data set includes data that is more closely related to a battery fault, the cloud BMS deeply diagnoses the battery based on the data from the second original data set of the vehicle, thereby more accurately determining a fault level of the battery.

With reference to the third aspect, in some possible implementations of the third aspect, that the vehicle and/or the cloud BMS deeply diagnose/diagnoses the battery based on the second original data set, to determine a fault level of the battery includes: The vehicle uploads the first diagnostic data and the second original data set to the cloud BMS. The cloud BMS deeply diagnoses the battery based on the second original data set and the first diagnostic data, to determine a fault level of the battery.

In other words, the data from the vehicle includes the second original data set and the first diagnostic data. A part or all of data in the second original data set may be uploaded to the cloud BMS. The first diagnostic data may include, for example, data obtained through deep diagnosis based on a part or all of data in the second original data set, which may be, for example, an eigenvalue extracted through feature engineering. The first diagnostic data is uploaded to the cloud BMS, in order that the cloud BMS may perform further deep diagnosis, thereby determining a fault level of the battery.

After the data obtained by the vehicle by performing deep diagnosis based on the second original data set is uploaded to the cloud BMS, the cloud BMS may deeply diagnose the battery. That is, the vehicle assists the cloud BMS in deeply diagnosing the battery, thereby reducing the computing resource consumption of the cloud BMS. Because data included in the second original data set is more abundant and comprehensive than data included in the first original data set and the second original data set includes data that is more closely related to a battery fault, the battery is deeply diagnosed based on the data, thereby more accurately determining a fault level of the battery.

With reference to the third aspect, in some possible implementations of the third aspect, that the vehicle and/or the cloud BMS deeply diagnose/diagnoses the battery based on the second original data set, to determine a fault level of the battery includes: The vehicle deeply diagnoses the battery based on the second original data set, to obtain first diagnostic data, where the first diagnostic data includes a fault level of the battery. The method further includes: The vehicle uploads the first diagnostic data to the cloud BMS.

In other words, the vehicle may deeply diagnose the battery based on the second original data set, to determine a fault level of the battery. In this case, the vehicle may directly upload the fault level of the battery to the cloud BMS, without a need of the cloud BMS for deep diagnosis.

Because data included in the second original data set is more abundant and comprehensive than data included in the first original data set and the second original data set includes data that is more closely related to a battery fault, the vehicle may deeply diagnose the battery based on the data in the second original data set to obtain first diagnostic data that includes a fault level of the battery, and upload the fault level of the battery to the cloud BMS, thereby reducing the computing resource consumption of the cloud BMS.

With reference to the third aspect, in some possible implementations of the third aspect, when the vehicle receives a risk warning, the method further includes: The vehicle performs an OTA upgrade based on an OTA upgrade package, where the OTA upgrade package comes from the cloud BMS or the vehicle.

Therefore, when it is predicted that the battery has a fault, the vehicle may control the battery in advance in an OTA upgrade manner, thereby avoiding further deterioration of the battery fault and reducing the accident occurrence rate.

Optionally, the OTA upgrade package includes a charge/discharge adjustment policy. That the vehicle performs an OTA upgrade based on an OTA upgrade package includes: The vehicle adjusts a maximum degree of charge and/or a maximum depth of discharge of the battery according to the charge/discharge adjustment policy.

When receiving the risk warning, the vehicle may determine that the battery may have a specific fault risk. The vehicle adjusts a maximum degree of charge and/or a maximum depth of discharge of the battery based on the OTA upgrade package from the cloud BMS, and controls the battery in advance, thereby avoiding further deterioration of the battery fault and reducing the accident occurrence rate. For example, a risk of spontaneous combustion or explosion caused by the fault in the battery may be reduced.

With reference to the third aspect, in some possible implementations of the third aspect, that the vehicle and/or the cloud BMS deeply diagnose/diagnoses the battery based on the second original data set includes: The vehicle and/or the cloud BMS deeply diagnose/diagnoses the battery based on a fault type of the battery and the second original data set by using a corresponding diagnostic model.

Based on the fault type of the battery, the battery may be deeply diagnosed more pertinently, thereby more accurately determining a fault level of the fault type of the battery.

According to a fourth aspect, this application provides a battery fault diagnosis method. The method may be performed by a battery fault diagnosis system that includes a vehicle BMS and a cloud BMS.

For example, the method includes: The vehicle BMS uploads a first original data set obtained from a vehicle through collection to the cloud BMS. The cloud BMS preliminarily diagnoses a battery based on the first original data set and sends a risk warning to the vehicle BMS based on the preliminary diagnosis for the battery. The vehicle BMS obtains a second original data set based on the received risk warning. The risk warning is sent based on the diagnosis for the battery. The second original data set is obtained from the vehicle through collection, and data items included in the second original data set are more than data items included in the first original data set or a data collection frequency of the second original data set is higher than a data collection frequency of the first original data set. The vehicle BMS and/or the cloud BMS deeply diagnose/diagnoses the battery based on the second original data set, to determine a fault level of the battery.

It should be understood that the vehicle BMS may be a BMS configured in the vehicle, and may be configured to implement the method in the second aspect and any one of the possible implementations of the second aspect, or the method performed by the vehicle in the third aspect and any one of the possible implementations of the third aspect, to obtain the same beneficial effect. For brevity, details are not described herein again.

With reference to the foregoing aspects, in some possible implementations, the data in the first original data set may include data in a GB/T 32960 standard.

For example, data in the first original data set may include vehicle data, drive motor data, fuel cell data, engine data, vehicle location data, extremum data, alarm data, and some reserved user-defined data items.

With reference to the foregoing aspects, in some possible implementations, the first original data set and the second original data set include data from an in-vehicle communication link of the vehicle, and data items from the in-vehicle communication link of the vehicle in the second original data set are more than data items from the in-vehicle communication link of the vehicle in the first original data set.

By way of example but not limitation, the in-vehicle communication link may be, for example, a controller local area network (controller area network, CAN).

With reference to the foregoing aspects, in some possible implementations, the data in the second original data set further includes data collected by an electrochemical impedance spectroscopy (electrochemical impedance spectroscopy, EIS) chip and/or test environment data.

It can be seen therefrom that data included in the second original data set is more abundant and comprehensive than data included in the first original data set, and the second original data set includes data that is more closely related to a battery fault. The cloud BMS deeply diagnoses the battery based on the data, to more accurately determine whether the battery has a fault, and more accurately determine a fault level of the battery.

With reference to the foregoing aspects, in some possible implementations, the risk warning indicates a risk level of the battery and/or a fault type of the battery.

The cloud BMS may remind a vehicle owner of the risk by sending a risk warning to the vehicle. In this way, when receiving the risk warning, the vehicle owner may transport the vehicle to a vehicle vendor for deep diagnosis, or perform operations such as battery replacement and maintenance, to reduce an accident occurrence rate.

Optionally, the risk level is used to determine a degree of emergency of the deep diagnosis, and different risk levels correspond to different degrees of emergency. In a possible implementation, different time limits are designed for different risk levels. For example, a time limit corresponding to a high risk level is shorter than a time limit corresponding to a low risk level. The time limit is specifically a time limit for delivering the vehicle to a vehicle vendor for deep diagnosis.

Different risk levels may prompt the vehicle owner to take corresponding countermeasures. For example, when the degree of emergency is relatively high, the vehicle is delivered to the vehicle vendor for deep diagnosis immediately. When the degree of emergency is relatively low, the vehicle may not be delivered to the vehicle vendor for deep diagnosis temporarily, but may be subjected to battery replacement and maintenance and other operations, thereby providing a better user experience.

Optionally, the fault type includes one or more of the following: thermal runaway, internal short circuit, poor consistency, overtemperature, undervoltage, or overvoltage.

The risk warning may enable a driver to learn a fault type of a battery and/or a risk level that the battery has a fault, and help the driver make a correct processing decision, thereby reducing a safety risk caused by the battery fault to the driver as much as possible.

With reference to the foregoing aspects, in some possible implementations, each fault type corresponds to one diagnostic model, and each diagnostic model is configured to preliminarily diagnose a battery of a corresponding fault type.

Further, the deeply diagnosing the battery based on the second original data set includes: deeply diagnosing the battery based on a fault type of the battery and the second original data set by using a corresponding diagnostic model.

Based on the fault type of the battery, the battery may be deeply diagnosed more pertinently, whereby a fault level of the fault type of the battery may be more accurately determined. Moreover, a fault less prone to a fault risk will not be deeply diagnosed additionally, thereby reducing unnecessary computing overheads.

With reference to the foregoing aspects, in some possible implementations, the preliminary diagnosis or the deep diagnosis uses one or more algorithms of mechanism analysis, knowledge graph and reasoning, big data analysis, digital twin, or analog simulation.

By using multiple algorithms for diagnosis, advantages of the various algorithms may be integrated to facilitate obtaining of a more accurate diagnostic result.

According to a fifth aspect, this application provides a battery fault diagnosis apparatus. The apparatus may be configured to implement the method in the first aspect or any one of the possible implementations of the first aspect, or the apparatus may be configured to implement the method in the second aspect or any one of the possible implementations of the second aspect. The apparatus includes corresponding modules configured to perform the foregoing method. The modules included in the apparatus may be implemented through software and/or hardware.

According to a sixth aspect, this application provides a battery fault diagnosis apparatus, including a processor. The processor is coupled to a memory, and may be configured to execute a computer program in the memory, to implement the method in the first aspect or any one of the possible implementations of the first aspect, or to implement the method in the second aspect or any one of the possible implementations of the second aspect.

Optionally, the battery fault diagnosis apparatus further includes a memory.

Optionally, the battery fault diagnosis apparatus further includes a communication interface, and the processor is coupled to the communication interface.

With reference to the fifth aspect and the sixth aspect, in some possible implementations, the diagnosis apparatus is a cloud BMS, or a chip, a chip system, or the like that may be used for a function of a cloud BMS.

With reference to the fifth aspect and the sixth aspect, in some possible implementations, the diagnosis apparatus is a vehicle, a vehicle BMS, or a chip, a chip system, or the like that may be used for a function of a vehicle BMS.

According to a seventh aspect, this application provides a cloud BMS, including a memory and a processor. The memory is configured to store program code. The processor is configured to invoke the program code to implement the method in the first aspect or any one of the possible implementations of the first aspect.

According to an eighth aspect, this application provides a vehicle BMS, including a memory and a processor. The memory is configured to store program code. The processor is configured to invoke the program code to implement the method in the second aspect or any one of the possible implementations of the second aspect.

According to a ninth aspect, this application provides a vehicle, including a memory and a processor. The memory is configured to store program code. The processor is configured to invoke the program code to implement the method in the second aspect or any one of the possible implementations of the second aspect.

Optionally, the vehicle includes the vehicle BMS in the eighth aspect, to implement the method in the second aspect or any one of the possible implementations of the second aspect.

According to a tenth aspect, this application provides a battery fault diagnosis system, including a vehicle and a cloud BMS. The system is configured to implement the method in the third aspect or any one of the possible implementations of the third aspect.

The vehicle may be, for example, the vehicle in the ninth aspect, and the cloud BMS may be, for example, the cloud BMS in the seventh aspect.

According to an eleventh aspect, this application provides a battery fault diagnosis system, including a vehicle BMS and a cloud BMS. The system is configured to implement the method in the fourth aspect or any one of the possible implementations of the fourth aspect.

The vehicle BMS may be, for example, the vehicle BMS in the eighth aspect, and the cloud BMS may be, for example, the cloud BMS in the seventh aspect.

According to a twelfth aspect, this application provides a chip system. The chip system includes at least one processor, configured to support implementation of functions in the first aspect to the fourth aspect and any one of the possible implementations of the first aspect to any one of the possible implementations of the fourth aspect, for example, receiving or processing data and/or information in the foregoing method.

In a possible design, the chip system further includes a memory. The memory is configured to store a program instruction and data, and the memory is located inside or outside the processor.

The chip system may include a chip, or may include a chip and another discrete device.

According to a thirteenth aspect, this application provides a computer-readable storage medium. The computer storage medium stores a computer program (which may also be referred to as code or instructions). When the computer program is run by a processor, the methods in the first aspect to the fourth aspect and any one of the possible implementations of the first aspect to any one of the possible implementations of the fourth aspect are performed.

According to a fourteenth aspect, this application provides a computer program product, including a computer program (which may also be referred to as code or instructions). When the computer program is run, the methods in the first aspect to the fourth aspect and any one of the possible implementations of the first aspect to any one of the possible implementations of the fourth aspect are performed.

It should be understood that the technical solutions in the fifth aspect to the fourteenth aspect of this application correspond to the technical solutions in the first aspect to the fourth aspect of this application, and beneficial effects achieved in the aspects and corresponding feasible implementations are similar. Details are not described again.

### BRIEF DESCRIPTION OF DRAWINGS

FIG. 1 shows a system architecture applicable to an embodiment of this application;
FIG. 2 is a schematic flowchart of a battery fault diagnosis method according to an embodiment of this application;
FIG. 3 is a schematic diagram of cooperative work between a cloud BMS and a vehicle applicable to an embodiment of this application;
FIG. 4 is a schematic diagram of an algorithm-based diagnosis applicable to an embodiment of this application;
FIG. 5 is a schematic block diagram of a battery fault diagnosis apparatus according to an embodiment of this application;
FIG. 6 is another schematic block diagram of a battery fault diagnosis apparatus according to an embodiment of this application; and
FIG. 7 is still another schematic block diagram of a battery fault diagnosis apparatus according to an embodiment of this application.

### DESCRIPTION OF EMBODIMENTS

The following describes technical solutions of this application with reference to the accompanying drawings.

To clearly describe the technical solutions in embodiments of this application, the following descriptions are first provided.

First, in embodiments of this application, words such as "first" and "second" are used to distinguish between same or similar items that have basically a same function and effect. For example, a first original data set and a second original data set are used to distinguish between different original data sets, and a sequence of the first original data set and the second original data set is not limited. A person skilled in the art may understand that the terms such as "first" and "second" do not limit a quantity or an execution sequence, and the terms such as "first" and "second" do not indicate a definite difference.

Second, in embodiments of this application, "at least one" means one or more. "And/or" is an association relationship describing associated objects, and indicates that three relationships may exist. For example, A and/or B may indicate that only A exists, both A and B exist, and only B exists. A and B each may be singular or plural. The character "/" usually indicates that association objects are in an "or" relationship, but does not exclude a case in which association objects are in an "and" relationship. A specific meaning indicated by the character "/" may be understood with reference to the context.

Third, in embodiments of this application, the terms "include", "have" and any other variants mean to cover a non-exclusive inclusion. For example, a process, method, system, product, or device that includes a list of steps or units is not necessarily limited to those steps or units, but may include other steps or units not expressly listed or inherent to such a process, method, product, or device.

First, the terms used in this application are briefly described.
1. Mechanism analysis: A scientific research method to find out rules of development and change by analyzing internal causes (mechanisms) of a system.

The mechanism analysis method is based on revealing an inner law of things. According to the understanding of characteristics of real objects, a causal relationship is analyzed, and a law reflecting an internal mechanism is found. The characteristics of real objects include, for example, knowledge related to a problem in terms of physics, chemistry, and the like. Data and phenomena are analyzed to obtain the inner law of things.

2. Knowledge graph: A modern theory that integrates theories and methods of applied mathematics, graphics, information visualization technologies, and information science with methods such as metrology citation analysis and co-presentation analysis, and uses visualized graphs to intuitively display the core structure, development history, frontier fields, and overall knowledge architecture of a subject to achieve multi-disciplinary integration.

The knowledge graph may include interconnected entities and attributes thereof. The knowledge graph is also referred to as a knowledge domain visualization or knowledge field map. The knowledge graph is a series of different graphs that display a knowledge development process and a structure relationship, uses visualization technologies to describe knowledge resources and carriers thereof, and explores, analyzes, constructs, draws, and displays knowledge and relationships therebetween.

3. Knowledge reasoning: is also referred to as reasoning for short. A computing process of deducing an unknown fact based on a known fact. New knowledge or conclusions are obtained through various methods.

4. Digital twin: is also referred to as digital twins or digital mapping. The digital twin is a process of digitally defining and modeling the composition, features, functions, and performance of physical entities by using information technologies. A digital twin body is an information model that is completely equivalent to a physical entity and exists in a computer virtual space. The physical entity may be simulated, analyzed, and optimized based on the digital twin body. The digital twin is a technology, process, and method. The digital twin body is an object, model, and data.

5. OTA upgrade: System upgrade, including firmware upgrade and software upgrade. The OTA upgrade may be used to improve or fix vulnerabilities, obtain more functions, improve performance, or improve visual effect. The upgrade includes online detection, version matching, and new code downloading locally for installation and verification after networking.

6. Controller area network (CAN) bus: An example of an in-vehicle communication link. The CAN bus is a serial communication network which effectively supports distributed control or real-time control. The CAN bus is used for connection between components of a vehicle. For example, the CAN bus may be connected to components including a CAN controller chip, a data receiver, a data sender, and the like.

7. Central gateway: is referred to as a gateway GW) for short. The GW serves as a data exchange hub of a vehicle network, wherein data may be securely and reliably transmitted in a plurality of networks (for example, a CAN, a local interconnect network (LIN), a vehicle optical fiber (MOST), and a flex ray) inside the vehicle. Related hardware of the GW may include a switch, transceivers of various network types (CAN, LIN, MOST, FlexRay, and the like), a system chip, and the like.

8. Vehicle control unit (VCU): A core electronic control unit that implements vehicle control decisions and functions as a brain of a vehicle. As the command and management center of a vehicle, the VCU mainly controls driving torque, optimizes braking energy, manages vehicle energy, maintains and manages the CAN, diagnoses and handles faults, and monitors vehicle status, and controls vehicle running.

In embodiments of this application, the VCU may report the collected related data to the GW, and may further send an execution command downwards. Related hardware of the VCU may include a VCU housing, a standardized core module circuit (for example, a processor, a power supply, a memory, and a CAN), and a VCU dedicated circuit (for example, a collector and a sensor).

9. Telematics box (T-Box): An interface for external communication of a vehicle, which may provide service functions such as remote control, remote query, and safety protection. Hardware of the T-Box may include: a T-Box housing, an internal wireless fidelity (Wi-Fi) module, a radio frequency inductor, a power inductor, a crystal resonator, a ceramic resonator, a thermistor, a battery, and the like.

10. BMS: is also referred to as a battery nanny or battery manager, which intelligently manages and maintains battery units, prevents battery overcharge and overdischarge, prolongs battery service lives, and monitors battery states.

A vehicle BMS includes various sensors, actuators, controllers, and signal lines. To meet related standards or specifications, the vehicle BMS should have the following functions.

### (1) Battery parameter detection:

For example, battery parameters may include a total voltage, a total current, a single cell voltage, a temperature, smoke, insulation, collision detection, and the like.

### (2) Battery state estimation:

For example, battery states may include a battery state of charge (SOC) or a depth of discharge (DOD), a battery state of health (SOH), a state of function (SOF), a state of energy (SOE), a fault and state of safety (SOS), and the like.

The SOH may be represented as a percentage of a current capacity of the battery to a factory capacity, and may be used to describe an aging degree of the battery. Therefore, the SOH is a quantitative indicator used to indicate a degree of health of the battery. In embodiments of this application, the SOH may be used as an output of preliminary diagnosis, to determine whether a warning prompt needs to be sent. For ease of description, a battery state of health is referred to as a state of health for short in the following.

### (3) Online fault diagnosis:

For example, the online fault diagnosis may include fault detection, fault type determination, fault locating, fault information output, and the like.

### (4) Battery safety control and alarm:

For example, after diagnosing a fault, the BMS generates an alarm to prevent damage to a battery and a person caused by high temperature, low temperature, overcharge, overdischarge, overcurrent, electric leakage, and the like.

### (5) Charge control:

For example, the BMS controls, based on characteristics of a battery, a temperature magnitude, and a power level of a charger, the charger to safely charge the battery.

### (6) Battery balancing:

For example, the capacity of a battery pack is less than the capacity of the smallest cell in the battery pack because of inconsistency. The battery balancing is to use active or passive balancing, dissipative balancing, or non-dissipative balancing based on cell information to ensure that the capacity of the battery pack is close to the minimum cell capacity.

### (7) Heat management:

For example, the BMS determines intensity of active heating/heat dissipation based on temperature distribution information in the battery pack and charge/discharge requirements, wherein the battery works at a most suitable temperature as possible, and performance of the battery is fully utilized.

### (8) Network communication:

For example, the BMS needs to communicate with another module of the system, to transmit and control data.

### (9) Information storage:

For example, key data, such as SOC, SOH, SOF, SOE, an accumulated ampere hours (ampere hours, Ah) quantity of charge and discharge, fault code, and consistency, is stored.

The vehicle BMS may include a battery management module, a control module, a display module, a wireless communication module, an electrical device, a battery pack configured to supply power to the electrical device, a collection module configured to collect battery information of the battery pack, and the like.

In embodiments of this application, related hardware of the vehicle BMS may include a component configured to perform data collection and a component that ensures a core function of the BMS, such as a relay driver, a state sampling component, an electrochemical cell equalization component, a power component, an SOE component, an SOC collection component, an AC/DC charge component, a charger state detection component, a thermal state component, a cooling component, and a sleep/wakeup component.

11. EIS: Observe a battery response mode by applying AC excitation of different frequencies to a battery, and obtain internal impedance frequency response characteristics of the battery at different frequencies. The EIS can reflect the state of health, state of fault, and internal temperature state of the battery. However, the EIS is strongly coupled and may be learned through big data processing on the cloud BMS.

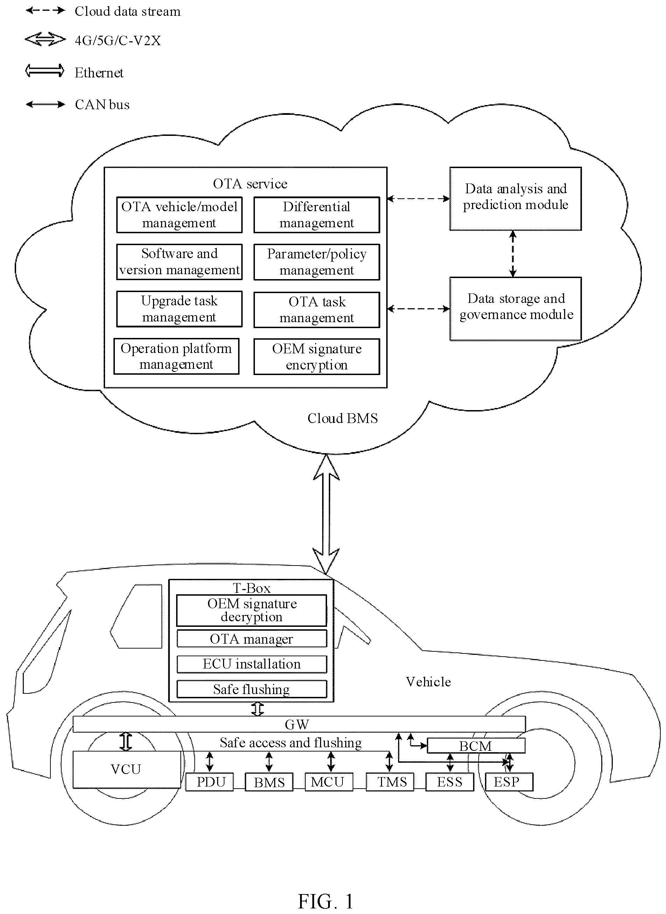

FIG. 1 shows a system architecture applicable to an embodiment of this application. In a system architecture shown in FIG. 1, a cloud BMS may communicate with a vehicle. For example, data may be transmitted by using a standard protocol such as 4G/5G/cellular vehicle-to-everything (cellular vehicle-to-everything, C-V2X). A process in which the vehicle transmits data to the cloud BMS may be referred to as uplink data transmission, and a process in which the cloud BMS transmits data to the vehicle may be referred to as downlink data transmission.

As shown in FIG. 1, the vehicle may include a T-Box, a GW, a VCU, a BMS, and the like. The T-Box may include modules for decryption of an original equipment manufacturer ( OEM) signature, installation and safe flushing of an OTA manager and an electronic control unit (ECU). This is not limited in this application.

It should be noted that in an actual application scenario, the vehicle may further include a body control module (BCM), an emergency signal system (ESS), a body stabilization system (ESP), a power distribution unit (PDU), a motor control unit (MCU), a transportation management system (TMS), and the like. This is not limited in this application.

The vehicle may further include a BMS. For ease of differentiation, the BMS may be referred to as a vehicle BMS. The vehicle (for example, vehicle BMS) may collect data, and report the collected data to the VCU in a unified manner. The VCU module may manage and process the data. For example, the VCU may report the data to the GW by using the Ethernet. The GW may perform data aggregation processing. For example, the GW may report data to the T-Box by using the Ethernet. The T-Box may transmit the data to the cloud by using the standard protocol such as 4G/5G/C-V2X.

The cloud BMS may include an OTA service module, a data analysis and prediction module, a data storage and governance module, and the like. The OTA service module may include modules such as OTA vehicle/model management, differential management, software and version management, parameter/policy management, upgrade task management, OTA task management, operation platform management, and OEM signature encryption. This is not limited in this application. After receiving data from the vehicle, the cloud BMS may perform processing such as OTA upgrade, data analysis and prediction, and data storage and governance on the data by using the OTA service module, the data analysis and prediction module, and the data storage and governance module. The cloud BMS may perform OEM signature encryption on the data of the cloud BMS to ensure data integrity and safety. The cloud BMS may transmit the data of the cloud BMS to the vehicle by using the standard protocol such as 4G/5G/C-V2X.

After the vehicle receives the data from the cloud BMS based on the T-Box, the T-Box may perform processing such as decryption and OEM signature decryption on the data to confirm data integrity and safety. After confirming that the data passes the safety check, the data is flushed safely, and sent to the GW through the Ethernet. If the data does not pass the safety check, the data may be discarded, recorded, or reported as an alarm. After receiving the data from the T-Box, the GW may identify and determine the data. For example, data related to a power domain may be flushed into the VCU through safe access. After completing data processing, the VCU may flush the data to the BMS through safe access.

With the wide application of electric vehicles, more and more attention is paid to the fault diagnosis of power batteries. Battery faults greatly affect running of vehicles, and even bring personal and property safety. Therefore, real-time faults of batteries need to be predicted and diagnosed, and then the batteries are controlled based on diagnostic results, thereby reducing a serious consequence that may be caused by the faults, and improving safety.

Currently, battery fault diagnosis is mainly based on a related industry standard, such as GB/T 32960. Data is collected from a vehicle BMS, and fault diagnosis is performed based on the collected data. For example, the vehicle described above collects data on the BMS and uploads the data to the cloud BMS, and the cloud BMS processes the data from the vehicle and then transmits some data to the vehicle. However, data collected from the vehicle BMS is limited, and fault diagnosis performed based thereon may have a specific error. A battery troubleshooting solution may be improper, and this may cause a safety risk, a waste of resources, or the like.

Therefore, embodiments of this application provide a battery fault diagnosis method and apparatus. A cloud BMS may first preliminarily diagnose a battery based on a small amount of data, and deeply diagnose, when it is predicted that the battery has a fault risk, the battery based on data in more dimensions and/or data collected at a higher frequency, thereby improving battery fault diagnosis accuracy.

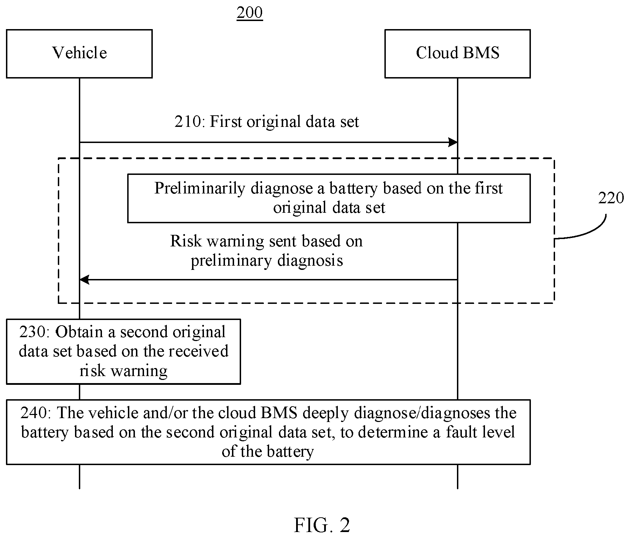

FIG. 2 is a schematic flowchart of a battery fault diagnosis method according to an embodiment of this application.

The method may be performed by a battery fault diagnosis system. The system includes a vehicle and a cloud battery management system BMS. Steps performed by the vehicle may be specifically performed by a vehicle BMS, or may be performed by another module. This is not limited in this application.

As shown in FIG. 2, the method 200 includes step 210 to step 240. The following describes the steps in detail.

In step 210, the vehicle uploads a first original data set to the cloud BMS. Correspondingly, the cloud BMS receives the first original data set from the vehicle.

The first original data set is obtained from the vehicle through collection. For example, data in the first original data set may include data in a GB/T 32960 standard. For example, the data in the first original data set may include vehicle data, drive motor data, fuel cell data, engine data, vehicle location data, extremum data, alarm data, and some reserved user-defined data items.

It should be noted that the first original data set may include data from an in-vehicle communication link. By way of example but not limitation, the in-vehicle communication link includes a CAN bus.

In step 220, the cloud BMS preliminarily diagnoses a battery based on the first original data set, and sends a risk warning to the vehicle based on the preliminary diagnosis for the battery. Correspondingly, the vehicle receives the risk warning from the cloud BMS.

It should be understood that the risk warning is sent based on the preliminary diagnosis for the battery.

In this embodiment of this application, the cloud BMS may perform analysis and reasoning based on the first original data set to preliminarily diagnose the battery, to obtain a state of health of the battery or a fault probability of the battery, and then may preliminarily determine, based on the state of health or the fault probability of the battery, whether the battery has a risk. If the battery has a risk, a risk warning may be sent to the vehicle, to invite the vehicle to pull in for deep diagnosis.

As described above, the state of health is a quantitative indicator used to indicate a degree of health of the battery. A larger value of the state of health indicates a better health status, and a smaller value of the state of health indicates a worse health status. Correspondingly, a preset threshold used to determine whether the battery has a risk is denoted as a first preset threshold. That the state of health reaches the first preset threshold may mean that the state of health is lower than the first preset threshold.

In contrast, a higher fault probability value of the battery indicates a larger fault possibility of the battery, and a lower fault probability value of the battery indicates a smaller fault possibility of the battery. Correspondingly, a preset threshold used to determine whether the battery has a risk is denoted as a second preset threshold. That the fault probability of the battery reaches the second preset threshold may mean that the fault probability of the battery is higher than the second preset threshold.

Optionally, sending the risk warning to the vehicle based on the preliminary diagnosis for the battery may include: sending the risk warning to the vehicle when the state of health of the battery is less than the first preset threshold.

The cloud BMS may determine a diagnostic result based on the preliminary diagnosis for the battery. The diagnostic result includes the state of health of the battery. When the state of health is lower than the first preset threshold, the risk warning is sent to the vehicle, to warn a driver to perform corresponding processing.

In an example, the diagnostic result is the state of health of the battery, the state of health of the battery is a hundred-point system, and the first preset threshold is 90. If the state of health of the battery is greater than or equal to 90, it may be determined that the battery has no fault and the cloud BMS may not send the risk warning to the vehicle. If the state of health of the battery is less than 90, it may be determined that the battery has a specific fault risk and the cloud BMS may send the risk warning to the vehicle.

Optionally, sending the risk warning to the vehicle based on the preliminary diagnosis for the battery may include: sending the risk warning to the vehicle when the fault probability of the battery is higher than the second preset threshold.

In still another example, the diagnostic result is the fault probability of the battery, and the first preset threshold is 10%. If the fault probability of the battery is less than or equal to 10%, it may be determined that the battery has no fault and the cloud BMS may not send the risk warning to the vehicle. If the fault probability of the battery is greater than 10%, it may be determined that the battery has a specific fault risk and the cloud BMS may send the risk warning to the vehicle.

It should be understood that the foregoing manners of determining with reference to different thresholds whether the battery has a fault risk are merely examples, and should not constitute any limitation on this application.

Optionally, the risk warning may be used to indicate a risk level of the battery. The risk level is used to determine a degree of emergency of the deep diagnosis. Different risk levels correspond to different degrees of emergency

The cloud may further analyze and process the state of health of the battery or the fault probability of the battery that is obtained through analysis based on the first original data set, to obtain the risk warning used to indicate the risk level of the battery, so that the driver can determine the degree of emergency of deep diagnosis based on the risk level of the battery.

The risk level is related to the diagnostic result of the preliminary diagnosis performed by the cloud BMS for the battery. Diagnostic results with different value ranges correspond to different risk levels.

For example, the risk level may be divided into three levels: a risk level 1, a risk level 2, and a risk level 3.

In an example, the diagnostic result is the state of health of the battery and the state of health of the battery is a hundred-mark system. When the state of health of the battery is greater than or equal to a mark of 70 and less than a mark of 90, the cloud BMS may determine that the risk level of the battery is the risk level 1. When the state of health of the battery is greater than or equal to a mark of 50 and less than the mark of 70, the cloud BMS may determine that the risk level of the battery is the risk level 2. When the state of health of the battery is greater than or equal to a mark of 0 and less than the mark of 50, the cloud BMS may determine that the risk level of the battery is the risk level 3.

In another example, the diagnostic result is the fault probability of the battery. When the fault probability of the battery is greater than 10% and less than or equal to 30%, the cloud BMS may determine that the risk level of the battery is the risk level 1. When the fault probability of the battery is greater than 30% and less than or equal to 50%, the cloud BMS may determine that the risk level of the battery is the risk level 2. When the fault probability of the battery is greater than 50% and less than or equal to 100%, the cloud BMS may determine that the risk level of the battery is the risk level 3.

Different risk levels may correspond to different degrees of emergency. For example, the risk level 1 corresponds to the lowest degree of emergency, and the risk level 3 corresponds to the highest degree of emergency. For example, the risk level 1 may warn the driver to pull in to deeply diagnose the vehicle in a next time of a routine check on the vehicle, the risk level 2 may warn the driver to pull in to deeply diagnose the vehicle within several days, and the risk level 3 may warn the driver to immediately pull in to deeply diagnose the vehicle.

It should be understood that the foregoing division of the risk level into three levels is merely an example. This is not limited in this application. It should be further understood that division standards of vehicle vendors for the risk level are different from each other. The foregoing is merely an example, and should not constitute any limitation.

Optionally, the risk warning may be used to indicate a fault type of the battery.

By way of example but not limitation, the fault type includes one or more of the following: thermal runaway, internal short circuit, poor consistency, overtemperature, undervoltage, or overvoltage.

For example, the risk warning may indicate that the battery may have a thermal runaway fault and an overtemperature fault. For still another example, the risk warning may indicate that the battery may have an internal short circuit fault. For another example, the risk warning may indicate that the battery may have three faults: thermal runaway, internal short circuit, and undervoltage.

Optionally, the fault type of the battery may be determined based on the preliminary diagnosis for the battery.

The cloud BMS may preliminarily diagnose the battery based on the first original data set, to determine the fault type of the battery.

In a possible implementation, each fault type corresponds to one diagnostic model, and each diagnostic model is used to preliminarily diagnose a corresponding fault type of the battery.

For example, the thermal runaway fault may correspond to one diagnostic model, the internal short circuit fault may correspond to one diagnostic model, the poor consistency fault may correspond to one diagnostic model, the overtemperature fault may correspond to one diagnostic model, the undervoltage fault may correspond to one diagnostic model, and the overvoltage fault may correspond to one diagnostic model.

The cloud BMS may preliminarily diagnose, based on the first original data set by using the diagnostic model corresponding to the thermal runaway fault, whether the battery has the thermal runaway fault. The cloud BMS may preliminarily diagnose, based on the first original data set by using the diagnostic model corresponding to the internal short circuit fault, whether the battery has the internal short circuit fault. The cloud BMS may preliminarily diagnose, based on the first original data set by using the diagnostic model corresponding to the consistency fault, whether the battery has the consistency fault. The cloud BMS may preliminarily diagnose, based on the first original data set by using the diagnostic model corresponding to the overtemperature fault, whether the battery has the overtemperature fault. The cloud BMS may preliminarily diagnose, based on the first original data set by using the diagnostic model corresponding to the undervoltage fault, whether the battery has the undervoltage fault. The cloud BMS may preliminarily diagnose, based on the first original data set by using the diagnostic model corresponding to the overvoltage fault, whether the battery has the overvoltage fault.

If the cloud BMS preliminarily diagnoses, based on the diagnostic models respectively corresponding to the foregoing plurality of fault types, that the battery has one or more faults, the fault type of the battery may be indicated by using the risk warning.

To control the battery in a timely manner, avoid further deterioration of the fault of the battery, and reduce an accident occurrence rate, the vehicle may further perform an OTA upgrade before an entry test.

Optionally, when the vehicle receives the risk warning, the method 200 may further include: The vehicle performs an OTA upgrade based on an OTA upgrade package.

The OTA upgrade package may come from the cloud BMS or the vehicle.

In an example, when determining through preliminary diagnosis that the state of health of the battery or the fault probability reaches the preset threshold, the cloud BMS sends the OTA upgrade package to the vehicle, and the vehicle may perform the OTA upgrade based on the OTA upgrade package from the cloud. The cloud BMS may deliver both the OTA upgrade package and the risk warning to the vehicle, or may send the OTA upgrade package to the vehicle before or after sending the risk warning. This is not limited in this application.

In still another example, the OTA upgrade package may be pre-stored in the vehicle. When receiving the risk warning, the vehicle may obtain the pre-stored OTA upgrade package, and perform the OTA upgrade based on the OTA upgrade package.

In a possible design, the OTA upgrade package may include a charge/discharge adjustment policy. Performing the OTA upgrade based on the OTA upgrade package may include: adjusting a maximum degree of charge and/or a maximum depth of discharge of the battery according to the charge/discharge adjustment policy.

The vehicle may adjust the maximum degree of charge of the battery, or the maximum depth of discharge of the battery, or the maximum degree of charge and the maximum depth of discharge of the battery according to the charge/discharge adjustment policy included in the OTA upgrade package.

For example, the vehicle may decrease the maximum degree of charge and/or the maximum depth of discharge of the battery according to the charge/discharge adjustment policy. For example, the vehicle may adjust the maximum degree of charge of the battery from 100% to 85%, and/or may adjust the maximum depth of discharge of the battery from 100% to 90%. This is not specifically limited in this application.

For example, when the cloud BMS preliminarily diagnoses the battery based on the first original data set, then determines that the battery has the thermal runaway fault, and sends the risk warning to the vehicle to indicate that the battery may have a fault including thermal runaway, the vehicle may adjust the maximum degree of charge and/or the maximum depth of discharge of the battery according to the charge/discharge adjustment policy included in the OTA upgrade package.

It should be noted that, if the cloud BMS preliminarily diagnoses the battery based on the first original data set, and then determines that the battery has a fault such as internal short circuit, poor consistency, overtemperature, undervoltage, or overvoltage, the cloud BMS may send, to the vehicle, a risk warning indicating that the battery has the fault such as internal short circuit, poor consistency, overtemperature, undervoltage, or overvoltage; and the cloud BMS and the vehicle may perform processing according to an existing troubleshooting policy for the fault such as internal short circuit, poor consistency, overtemperature, undervoltage, or overvoltage, for example, prompting to periodically maintain or replace the battery. This is not limited in this application.

In step 230, the vehicle obtains a second original data set based on the received risk warning.

The second original data set is obtained from the vehicle through collection. In this embodiment of this application, both the first original data set and the second original data set include data obtained from the vehicle through collection, and a difference is that the first original data set may be used to preliminarily diagnose the battery and the second original data set may be used to deeply diagnose the battery. Specifically, data items included in the second original data set are more than data items included in the first original data set. Alternatively, a collection frequency of data in the second original data set is higher than a collection frequency of data in the first original data set.Data items included in the second original data set are more than data items included in the first original data set, and a collection frequency of data in the second original data set is higher than a collection frequency of data in the first original data set.

For example, the vehicle may use a corresponding troubleshooting policy based on information indicated by the received risk warning, for example, the risk level of the battery and/or the fault type of the battery. For example, the vehicle may determine, based on the risk level of the battery, a degree of emergency for a deep diagnosis, that is, determine a degree of emergency for obtaining the second original data set; or may obtain, based on the fault type of the battery, data related to the fault type as the second original data set for a deep diagnosis.

Optionally, the first original data set and the second original data set include data from an in-vehicle communication link of the vehicle, and data items from the in-vehicle communication link of the vehicle in the second original data set are more than data items from the in-vehicle communication link of the vehicle in the first original data set.

As described above, the in-vehicle communication link may include a CAN bus. For example, the vehicle may collect data of the vehicle including battery-related data through the BMS by using the CAN bus in cooperation with, for example, a PDU, an MCU, a TMS, an ESS, an ESP, and a BCM. Alternatively, the data in the second original data set may include data from the CAN bus, for example, a total package voltage, a current, an electricity quantity, and a power of the BMS; a system status of the BMS; a temperature of the BMS; a national standard data alarm of the BMS; a cell voltage of the BMS; fault alarm information of the BMS; extremum data of the BMS; a national standard data insulation resistance and a state of charge of the BMS; an SOE, an SOC, and an SOH of the battery; rotational speeds, torques, currents, voltages, states, and temperatures of front and rear motors; a state of a VCU; a temperature of a water inlet/outlet of a battery pack; national standard data of the MCU; data such as a state of a thermal runaway sensor, a flag, and an aerosol; a state of a direct-current converter, a state of a vehicle-mounted charger, and a mutual impact state of a vehicle-mounted charger; fault alarm information of the MCU, and the like.

Optionally, the data in the second original data set further includes data collected by an EIS chip and/or test environment data.

The second original data set may further include data collected by the ESI chip. Because the data collected by the ESI chip is closely related to the thermal runaway fault of the battery, when the battery is diagnosed based on the data collected by the ESI chip, it may be accurately determined whether the battery has the thermal runaway fault, thereby improving accuracy of determining a fault of the battery.

It should be noted that a vehicle for which an ESI chip can be configured can obtain the data collected by the ESI chip. A vehicle for which an ESI chip cannot be configured may not use the ESI chip to collect data.

The second original data set may further include test environment data, such as a geographical location, an environment temperature, an environment humidity, and a season of a test.

In addition, the second original data set may further include related information of the driver, such as an age and a behavior habit of the driver. The second original data set may further include data of a charge station, such as an environment area of the charge station, a charge start time, a charge end time, a charge current, a charge voltage, and a state of charge during charging. The second original data set may further include a use record of the battery, such as a use area, an environment temperature, and a charge frequency of the battery. This is not limited in this application.

In addition, the collection frequency of the second original data set may be higher than the collection frequency of the first original data set. For example, in specific implementation, the vehicle may collect the same data at different frequencies; or the vehicle may perform downsampling on the collected data when uploading the first original data set, and upload all the collected data when uploading the second original data set.

It can be learned from the foregoing that the second original data set has more abundant and comprehensive data than the first original data set. When the battery is diagnosed based on the second original data set, it can be more accurately determined whether the battery has a fault, and a fault level of the battery can be more accurately determined.

In step 240, the vehicle and/or the cloud BMS deeply diagnose/diagnoses the battery based on the second original data set, to determine the fault level of the battery.

For example, each fault type of the battery may be divided into three fault levels: a fault level 1, a fault level 2, and a fault level 3. Each fault type may correspond to a plurality of fault levels. For example, faults such as thermal runaway, internal short circuit, poor consistency, overtemperature, undervoltage, and overvoltage each may have three fault levels.

The fault level 1 and the fault level 2 are fault levels that require further observation. For the fault level 1 and the fault level 2, a troubleshooting policy may be to remind a customer that the battery has a potential fault risk and advise the customer to periodically check the battery. For the fault level 3, a troubleshooting policy may be to advise the customer to replace a battery pack immediately.

It should be understood that division of fault levels and corresponding troubleshooting policies may be determined by each vehicle vendor. The foregoing examples are merely illustrated for ease of understanding, and should not constitute any limitation on this application.

As described above, one fault type may correspond to one diagnostic model. Optionally, step 240 may include: The vehicle and/or the cloud BMS deeply diagnose/diagnoses the battery based on the fault type of the battery and the second original data set by using a corresponding diagnostic model.

The vehicle and/or the cloud BMS may determine a corresponding diagnostic model based on the fault type of the battery indicated in the risk warning, and deeply diagnose the battery by using the diagnostic model based on the second original data set. In other words, the vehicle and/or the cloud BMS may first determine the fault type of the battery through the preliminary diagnosis, determine, based on a correspondence between a fault type and a model, a diagnostic model for the deep diagnosis, and then deeply diagnose the battery based on the determined diagnostic model and the data in the second original data set, to finally determine the fault level of the fault of the battery.

Optionally, the preliminary diagnosis or the deep diagnosis uses one or more algorithms of mechanism analysis, knowledge graph and reasoning, big data analysis, digital twin digital, or analog simulation.

In other words, in either of the preliminary diagnosis and the deep diagnosis, one or more algorithms of mechanism analysis, knowledge graph and reasoning, big data analysis, digital twin, or analog simulation may be used.

It should be understood that the knowledge graph and reasoning, big data analysis, and digital twin listed above are all AI algorithms. Therefore, the foregoing preliminary diagnosis or deep diagnosis may use one or more algorithms of an AI algorithm, mechanism analysis, or analog simulation. Certainly, the AI algorithm is not limited to the several algorithms listed above. This is not limited in this application.

In an example, the cloud BMS may preliminarily diagnose the battery based on the first original data set by using one or more algorithms of mechanism analysis, knowledge graph and reasoning, big data analysis, digital twin, or analog simulation.

In another example, the vehicle BMS and/or the cloud BMS may deeply diagnose the battery based on the second original data set by using one or more algorithms of mechanism analysis, knowledge graph and reasoning, big data analysis, digital twin, or analog simulation.

In still another example, the cloud BMS may first preliminarily diagnose the battery based on the first original data set by using one or more algorithms of mechanism analysis, knowledge graph and inference, big data analysis, digital twin, or analog simulation. After the preliminary diagnosis, the vehicle BMS and/or the cloud BMS may preliminarily diagnose the battery based on the second original data set by using one or more algorithms of mechanism analysis, knowledge graph and reasoning, big data analysis or analog simulation, and digital twin.

The AI algorithm may be trained in the following model training manners.

Manner 1: A global model is adopted. That is, all vehicles are of the same model. This model is oriented to a specific task or function, such as fault warning or capacity estimation. The model may be directly used for result decision processing in these scenarios. Feature information (such as fault or capacity-related features) is extracted from a training sample vehicle, a model is trained, and decision processing prediction is performed on data of each vehicle on the cloud BMS based on the model to obtain a decision processing result (such as fault warning) as a policy presented to operation and maintenance personnel of a vehicle vendor, whereby the operation and maintenance personnel of the vehicle vendor may control the vehicle based on the decision processing result.

That is to say, the cloud BMS trains the global model. The model is trained based on all collected vehicle data, and a decision processing result of each vehicle is provided based on the model. The vehicle may not perform training decision processing.

Manner 2: Local models are adopted. That is, one model corresponds to one type of vehicle or one model corresponds to one vehicle. Similar to the global model, these models are also oriented to a specific task. The cloud BMS extracts features from the data of a specific type of vehicles or each vehicle, trains AI algorithm models, and makes decisions on the corresponding vehicles based on these models.

That is to say, the cloud BMS trains a local model. The local models may be a vehicle of a specific model or even a vehicle. A decision processing result of each vehicle is provided based on the model, and the vehicle may not perform training decision processing.

It should be noted that the global model or the local model may be trained in advance by the cloud BMS, may be periodically and incrementally trained after being brought online, and does not need to be refreshed in real time.

Manner 3: A pre-training model is not oriented to a specific task or function, and a relationship between each data dimension of the vehicle and a feature of the vehicle in a specific time sequence and a working condition is learned from massive data, to form the pre-training model. The vehicle finely adjusts the model with reference to specific labeling data, thereby implementing tasks such as risk warning and capacity estimation with low resource consumption. For example, the cloud BMS stores a large amount of data such as a time sequence, a working condition, a driving behavior, a location, a total current, a total voltage, a cell voltage, a temperature, a motor state, a risk level, a fault type, and a level. The pre-training model learns a relationship between these dimensions and derivative features thereof through self-monitoring. When performing a task such as a 3-level risk warning task, the vehicle only needs to finely adjust the pre-training model with risk data with a label to obtain a model of the vehicle oriented to the 3-level risk warning task. This model has both common information learned from big data and unique information.

The foregoing training of the pre-training model is: learning, from massive data, a relationship between data dimension features of various batteries in various working conditions. The data dimension may include a time sequence, a vehicle speed, a current, a voltage, a temperature, a capacity, a fault type, and the like. A pre-training and learning relationship is a relationship between the foregoing data dimension and derivative features, for example, a relationship between the fault type and the vehicle speed, the current, the voltage, and the time sequence.

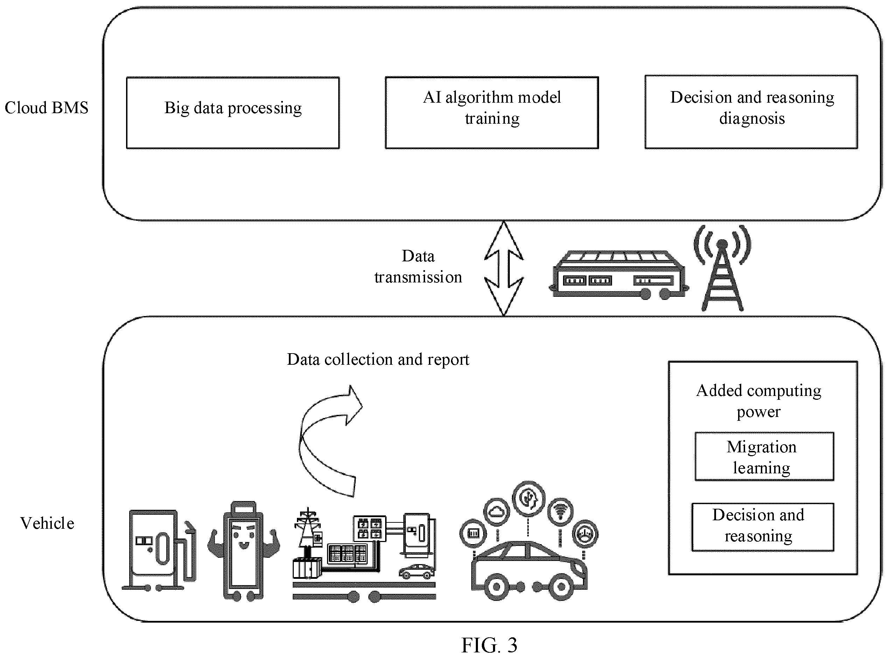

As shown in FIG. 3, a computing power may be added to a vehicle. In this way, the cloud BMS performs big data processing and training based on data uploaded by the vehicle to the cloud BMS, and a global or local model obtained is used as a pre-training model. The cloud BMS may issue parameters of the pre-training model to the vehicle. The vehicle uses the parameters of the pre-training model as initialization parameters of local model training of the vehicle, and performs model parameter optimization based on a small amount of collected data. That is, the vehicle may make a decision based on the locally trained model.

It should be noted that the pre-training model in Manner 3 is more complex than the global model and the local model. The advantages of the pre-training model are that the vehicle has AI model training and decision reasoning capabilities with a small hardware cost, thereby improving accuracy and reliability.

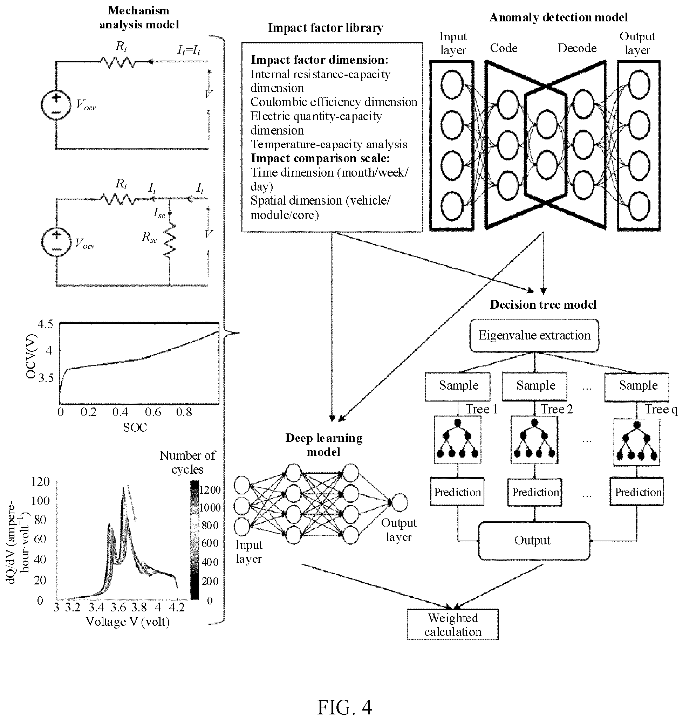

As shown in FIG. 4, a deep learning model, a decision tree model, and an anomaly detection model are all specific examples of AI algorithm models.

FIG. 4 shows an example of a process of preliminary diagnosis based on a first original data set. Data in the first original data set may be divided into three pieces of data. The first piece of data is used as input data of a mechanism analysis model. After the data is processed by using a mechanism analysis algorithm, some eigenvalues may be obtained, and the eigenvalues may be input into an impact factor library. The second piece of data may be converted into some eigenvalues through big data analysis, or the eigenvalues may be output into the impact factor library. The third piece of data may be input into the anomaly detection model to obtain an anomaly score of the vehicle. The eigenvalues obtained based on the first piece of data, the eigenvalues obtained based on the second piece of data, and the anomaly score obtained based on the third piece of data in the foregoing impact factor library are used as input data of the deep learning model and the decision tree model. After processing the data, the deep learning model and the decision tree model may output a state of health of the battery or a fault probability value of the battery, and perform weighted calculation on the states of health of the battery separately output by the two models, to obtain a final state of health of the battery, or perform weighted calculation on the fault probability values of the battery separately output by the two models, to obtain a final fault probability value of the battery. In this way, it may be determined, based on the state of health of the battery or the fault probability value of the battery, whether the battery has a fault, and a risk level of the fault in the battery may be determined, to complete preliminary diagnosis for the battery, that is, complete preliminary fault prediction for the battery.

It should be noted that each piece of the foregoing data may be a part or all of data in the first original data set, and is mainly determined based on data items required by each model. Data items required by different models may be the same or may be different. This is not limited in this application.

In still another example, deep diagnosis is performed based on the second original data set, and data related to diagnosing the fault type may be determined from the second original data set based on the fault type of the battery determined through preliminary diagnosis. The related data may be all data in the second original data set, or may be some data in the second original data set. Similarly, the data related to diagnosing the fault type may also be divided into three pieces of data. For the three pieces of data, refer to the three pieces of data obtained by dividing the data in the first original data set. For brevity, details are not described herein again. The eigenvalues obtained based on the first piece of data, the eigenvalues obtained based on the second piece of data, and the anomaly score obtained based on the third piece of data in the foregoing impact factor library are used as input data of the deep learning model and the decision tree model. After processing the data, the deep learning model and the decision tree model may output a fault probability value of the battery, and perform weighted calculation on the fault probability values of the battery separately output by the two models, to obtain a final fault probability value of the battery. In this way, a fault level of the fault in the battery may be determined based on a correspondence between the probability value of the fault in the battery and the fault level of the fault, to complete deep diagnosis for the battery, that is, further fault prediction for the battery.

It should be noted that each piece of the foregoing data may be a part or all of data in the second original data set, and is mainly determined based on data items required by each model. Data items required by different models may be the same or may be different. This is not limited in this application.

It should be understood that the foregoing process of preliminary diagnosis and deep diagnosis shown with reference to FIG. 4 is merely an example. As described above, either the preliminary diagnosis or the deep diagnosis may be implemented by using one or more algorithms of mechanism analysis, knowledge graph and reasoning, big data analysis, digital twin, or analog simulation. Specific implementations of each algorithm are internal implementations of a device. For specific algorithm logic of each algorithm, refer to the conventional technologies. For brevity, examples are not described one by one herein.

The following provides several possible implementations in which the vehicle and/or the cloud BMS perform the deep diagnosis based on the second original data set.

In a first possible implementation, the cloud BMS autonomously performs deep diagnosis.

Optionally, the method 200 may further include: The vehicle uploads the second original data set to the cloud BMS. Correspondingly, that the vehicle and/or the cloud BMS deeply diagnose/diagnoses the battery based on the second original data set, to determine a fault level of the battery may include: The cloud BMS deeply diagnoses the battery based on the received data, to determine a fault level of the battery.

For example, based on the fault type of the battery indicated in the risk warning, the vehicle may upload, to the cloud BMS pertinently, related data in the second original data set required for diagnosing whether the battery has the fault type indicated in the risk warning. The data uploaded to the cloud BMS may be all data in the second original data set, or may be some data in the second original data set. The cloud BMS may deeply diagnose the battery based on the received data from the vehicle, to determine a fault level of the battery.

For example, the cloud BMS may deeply diagnose the battery based on the received data by using the algorithm diagnosis process shown in FIG. 4, to determine a fault level of the battery.

In a second possible implementation, the vehicle and the cloud BMS may work cooperatively to deeply diagnose the battery.

Optionally, that the vehicle and/or the cloud BMS deeply diagnose/diagnoses the battery based on the second original data set, to determine a fault level of the battery includes: The vehicle obtains first diagnostic data based on the second original data set. The vehicle uploads the first diagnostic data and the second original data set to the cloud BMS. The cloud BMS deeply diagnoses the battery based on the second original data set, the first diagnostic data, and the second diagnostic data, to determine a fault level of the battery.

A possible implementation in which the cloud BMS deeply diagnoses the battery based on the second original data set and the first diagnostic data to determine a fault level of the battery is as follows: The cloud BMS performs processing based on the second original data set to obtain second diagnostic data, and performs analysis based on the first diagnostic data and the second diagnostic data to determine a fault level of the battery. The process of performing processing based on the second original data set and the process of performing analysis based on the first diagnostic data and the second diagnostic data may be considered as a specific implementation of the deep diagnosis.

For example, as shown in FIG. 3, the vehicle may increase a computing power, and the vehicle may perform analysis based on the second original data set to obtain first diagnostic data. The first diagnostic data may include the foregoing eigenvalues. The vehicle may upload a part or all of data in the first diagnostic data and the second original data set to the cloud BMS, and then the cloud BMS performs, based on the data in the second original data set, the algorithm diagnosis process shown in FIG. 4 on the battery, to obtain second diagnostic data. In this way, the cloud BMS may analyze the first diagnostic data and the second diagnostic data to obtain a fault level of the battery.

In a third possible implementation, the vehicle autonomously performs deep diagnosis.

Optionally, that the vehicle and/or the cloud BMS deeply diagnose/diagnoses the battery based on the second original data set, to determine a fault level of the battery may include: The vehicle deeply diagnoses the battery based on the second original data set, to obtain first diagnostic data, where the first diagnostic data includes a fault level of the battery. The method 200 further includes: The vehicle uploads the first diagnostic data to the cloud BMS.

For example, the vehicle may deeply diagnose the battery based on the second original data set by using the algorithm diagnosis process shown in FIG. 4, to obtain first diagnostic data including a fault level of the battery, and may upload the first diagnostic data to the cloud BMS.

In the foregoing three possible implementations, the cloud BMS may present, based on a display module, the determined fault level of the battery to the operation and maintenance personnel of the vehicle vendor, whereby the operation and maintenance personnel of the vehicle vendor may control the vehicle based on the fault level of the battery, to ensure safety of the vehicle. In addition, after a vehicle that is determined during preliminary diagnosis to have a thermal runaway fault adjusts the maximum degree of charge and/or the maximum depth of discharge of the battery according to the charge/discharge adjustment policy in the OTA upgrade package, and performs deep diagnosis based on the second original data set, a normal vehicle is not faulty is determined, and may be returned to the vehicle owner after the charge and discharge limitation is removed. Unpacking analysis is performed on a vehicle that is determined to be faulty after deep diagnosis, an analysis result may be returned to an algorithm, and the algorithm is further optimized, to further improve diagnosis accuracy.

Based on the foregoing solution, a vehicle may first upload a first original data set to a cloud BMS, whereby the cloud BMS preliminarily diagnoses a battery based on the first original data set. When receiving a risk warning from the cloud BMS, the vehicle may collect a second original data set used for deep diagnosis. Based on the deep diagnosis, the data items included in the second original data set are more than the data items included in the first original data set or the data collection frequency of the second original data set is higher than the data collection frequency of the first original data set. Alternatively, the data items included in the second original data set are more than the data items included in the first original data set and the data collection frequency of the second original data set is higher than the data collection frequency of the first original data set. That is, the deep diagnosis is based on more abundant and comprehensive data, whereby the battery may be more deeply diagnosed, thereby helping obtain a more accurate diagnostic result and improving battery fault diagnosis accuracy. In this way, operation and maintenance personnel may process the battery according to a fault level of the battery, to reduce serious consequences caused by a battery fault, and improve safety of the vehicle.

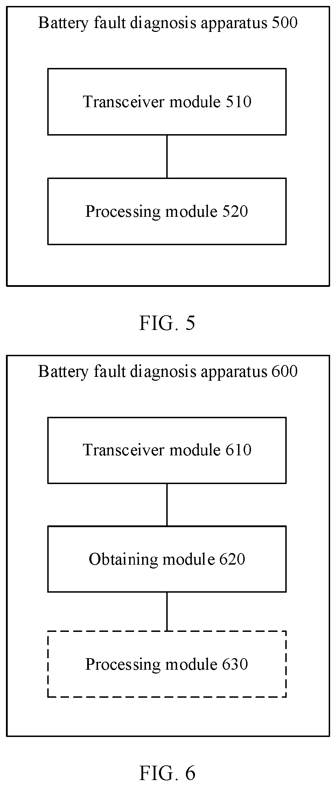

FIG. 5 is a schematic block diagram of a battery fault diagnosis apparatus according to an embodiment of this application. As shown in FIG. 5, the battery fault diagnosis apparatus 500 may include a transceiver module 510 and a processing module 520. The battery fault diagnosis apparatus 500 may be configured to perform the steps performed by the cloud BMS in the method 200. Optionally, the apparatus may be a cloud BMS, or a component configured in the cloud BMS, such as a chip or a chip system.

For example, the transceiver module 510 may be configured to receive a first original data set from a vehicle, where the first original data set is obtained from the vehicle through collection. The processing module 520 may be configured to preliminarily diagnose a battery of the vehicle based on the first original data set. The transceiver module 510 may be further configured to send a risk warning to the vehicle based on the preliminary diagnosis for the battery, and receive data from the vehicle. The data includes: a second original data set, or first diagnostic data obtained by the vehicle based on the second original data set. The second original data set is obtained from the vehicle through collection, the second original data set is used to deeply diagnose the battery, and data items included in the second original data set are more than data items included in the first original data set or a data collection frequency of the second original data set is higher than a data collection frequency of the first original data set.

Optionally, the processing module 520 is further specifically configured to deeply diagnose the battery based on the second original data set, to determine a fault level of the battery.

Optionally, the processing module 520 is further specifically configured to deeply diagnose the battery based on the second original data set and the first diagnostic data, to determine a fault level of the battery.

Optionally, the first diagnostic data includes a fault level of the battery, and the data from the vehicle includes the first diagnostic data.

Optionally, the processing module 520 may be specifically configured to determine a diagnostic result based on the preliminary diagnosis for the battery. The diagnostic result includes a state of health of the battery or a fault probability value of the battery. The transceiver module 510 may be further configured to send the risk warning to the vehicle when the diagnostic result reaches a preset threshold.

Optionally, the transceiver module 510 may be further configured to send an OTA upgrade package to the vehicle. The OTA upgrade package is used for an OTA upgrade of the vehicle.

Optionally, the OTA upgrade package includes a charge/discharge adjustment policy. The charge/discharge adjustment policy is used to adjust a maximum degree of charge and/or a maximum depth of discharge of the battery.

Optionally, the risk warning indicates a risk level of the battery and/or a fault type of the battery. The risk level is used to determine a degree of emergency of the deep diagnosis, and different risk levels correspond to different degrees of emergency. The fault type includes one or more of the following: thermal runaway, internal short circuit, poor consistency, overtemperature, undervoltage, or overvoltage.

Optionally, the fault type of the battery is determined based on the preliminary diagnosis for the battery.

Optionally, each fault type corresponds to one diagnostic model, and each diagnostic model is configured to preliminarily diagnose the battery of a corresponding fault type.

Optionally, the processing module 520 may be specifically configured to deeply diagnose the battery based on a fault type of the battery and the second original data set by using a corresponding diagnostic model.

Optionally, the preliminary diagnosis and/or the deep diagnosis use/uses one or more algorithms of mechanism analysis, knowledge graph and reasoning, big data analysis, digital twin, or analog simulation.

Optionally, the data in the first original data set and the second original data set include data from an in-vehicle communication link, and data items from the in-vehicle communication link of the vehicle in the second original data set are more than data items from the in-vehicle communication link of the vehicle in the first original data set.

Optionally, data in the second original data set further includes data collected by an EIS chip and/or test environment data.

FIG. 6 is another schematic block diagram of a battery fault diagnosis apparatus according to an embodiment of this application. As shown in FIG. 6, the battery fault diagnosis apparatus 600 may include a transceiver module 610 and an obtaining module 620. The battery fault diagnosis apparatus 600 may be configured to perform the steps performed by the vehicle in the method 200. Optionally, the apparatus may be a vehicle or a vehicle BMS, or a component configured in the vehicle or the vehicle BMS, such as a chip or a chip system.

For example, the transceiver module 610 may be configured to upload a first original data set obtained from the vehicle through collection to a cloud BMS. The first original data set is used to preliminarily diagnose a battery of the vehicle. When a risk warning from the cloud BMS is received, the obtaining module 620 may be configured to obtain a second original data set. The second original data set is used to deeply diagnose the battery. The risk warning is sent based on the preliminary diagnosis for the battery. The second original data set is obtained from the vehicle through collection, and data items included in the second original data set are more than data items included in the first original data set or a data collection frequency of the second original data set is higher than a data collection frequency of the first original data set. The transceiver module 610 may be further configured to send data to the cloud BMS. The data includes data in the second original data set, or first diagnostic data obtained by the vehicle based on the second original data set.

Optionally, the first diagnostic data includes a fault level of the battery. The battery fault diagnosis apparatus 600 further includes a processing module 630. The processing module 630 may be configured to deeply diagnose the battery based on the second original data set. The fault level is obtained by the apparatus 600 performing deep diagnosis based on the second original data set.

Optionally, the transceiver module 610 may be further configured to upload the second original data set and the first diagnostic data to the cloud BMS. The second original data set and the first diagnostic data are used by the cloud BMS to deeply diagnose the battery, to determine a fault level of the battery.

Optionally, the transceiver module 610 may be further configured to upload the second original data set to the cloud BMS. The second original data set is used by the cloud BMS to deeply diagnose the battery, to determine a fault level of the battery.

Optionally, the risk warning indicates a risk level of the battery and/or a fault type of the battery. The risk level is used to determine a degree of emergency of the deep diagnosis, and different risk levels correspond to different degrees of emergency. The fault type includes one or more of the following: thermal runaway, internal short circuit, poor consistency, overtemperature, undervoltage, or overvoltage.

Optionally, each fault type corresponds to one diagnostic model. The processing module 630 may be further configured to determine a corresponding diagnostic model based on a fault type of the battery indicated in the risk warning, and deeply diagnose the battery by using the diagnostic model based on the second original data set.

Optionally, when a risk warning from the cloud BMS is received, the processing module 630 may be further configured to perform OTA upgrade based on an OTA upgrade package. The OTA upgrade package is from the cloud BMS or the vehicle.

Optionally, the OTA upgrade package includes a charge/discharge adjustment policy. The processing module 630 may be further configured to adjust a maximum degree of charge and/or a maximum depth of discharge of the battery according to the charge/discharge adjustment policy.

Optionally, the preliminary diagnosis and/or the deep diagnosis use/uses one or more algorithms of mechanism analysis, knowledge graph and reasoning, big data analysis, digital twin, or analog simulation.

Optionally, the first original data set and the second original data set include data from an in-vehicle communication link of the vehicle, and data items from the in-vehicle communication link of the vehicle in the second original data set are more than data items from the in-vehicle communication link of the vehicle in the first original data set.

Optionally, data in the second original data set further includes data collected by an EIS chip and/or test environment data.

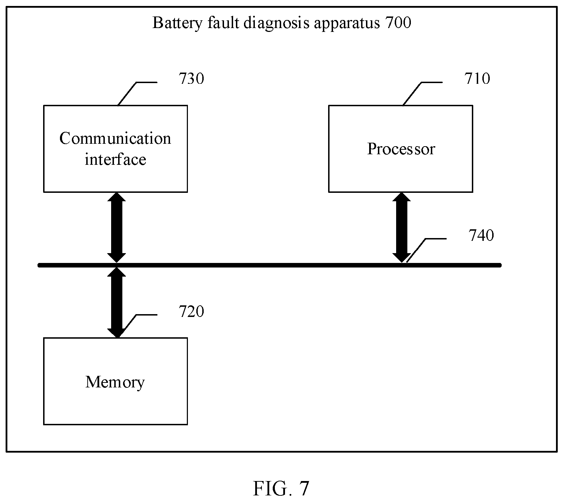

FIG. 7 is still another schematic block diagram of a battery fault diagnosis apparatus according to an embodiment of this application. The battery fault diagnosis apparatus 700 may be configured to implement functions of a cloud BMS or a vehicle (or a vehicle BMS) in this embodiment of this application. The battery fault diagnosis apparatus 700 may be a chip or a chip system. The chip system may include a chip, or include a chip and another discrete device.

As shown in FIG. 7, the battery fault diagnosis apparatus 700 may include at least one processor 710, configured to implement functions of a cloud BMS, a vehicle, or a vehicle BMS in the methods provided in this embodiment of this application.

For example, when the battery fault diagnosis apparatus 700 is configured to implement the functions of the cloud BMS in the method 200 provided in this embodiment of this application, the processor 710 may be configured to: control a communication interface 730 to receive a first original data set from the vehicle, where the first original data set is obtained from the vehicle through collection, preliminarily diagnose a battery of the vehicle based on the first original data set, and control the communication interface 730 to send a risk warning to the vehicle based on the preliminary diagnosis for the battery; and control the communication interface 730 to receive data from the vehicle, where the data includes a second original data set, or first diagnostic data obtained by the vehicle based on the second original data set, the second original data set is obtained from the vehicle through collection, the second original data set is used to deeply diagnose the battery, and data items included in the second original data set are more than data items included in the first original data set or a data collection frequency of the second original data set is higher than a data collection frequency of the first original data set. For details, refer to the detailed description in the method embodiments. Details are not described herein again.

For example, when the battery fault diagnosis apparatus 700 is configured to implement the function of the vehicle (or vehicle BMS) in the method 200 provided in this embodiment of this application, the processor 710 may be configured to: control the communication interface 730 to upload a first original data set obtained from the vehicle through collection to the cloud BMS, where the first original data set is used to preliminarily diagnose a battery of the vehicle; obtain, when a risk warning from the cloud BMS is received, a second original data set that is used to deeply diagnose the battery, where the risk warning is sent based on the preliminary diagnosis for the battery, the second original data set is obtained from the vehicle through collection, and data items included in the second original data set are more than data items included in the first original data set or a data collection frequency of the second original data set is higher than a data collection frequency of the first original data set; and control the communication interface 730 to send data to the cloud BMS, where the data includes data in the second original data set, or first diagnostic data obtained by the vehicle based on the second original data set. For details, refer to the detailed description in the method embodiments. Details are not described herein again.

The battery fault diagnosis apparatus 700 may further include at least one memory 720, configured to store a program instruction and/or data. The memory 720 is coupled to the processor 710. The coupling in this embodiment of this application is indirect coupling or a communication connection between apparatuses, units, or modules, may be in electrical, mechanical or other forms, and is used for information exchange between apparatuses, units or modules. The processor 710 may cooperate with the memory 720. The processor 710 may execute the program instructions stored in the memory 720. At least one of the one or more memories may be included in the processor.

The battery fault diagnosis apparatus 700 may further include a communication interface 730, configured to communicate with another device by using a transmission medium, so that an apparatus in the battery fault diagnosis apparatus 700 may communicate with the another device. For example, when the battery fault diagnosis apparatus 700 is configured to implement the functions of the cloud BMS in the method provided in this embodiment of this application, the another device may be a vehicle. When the battery fault diagnosis apparatus 700 is configured to implement the functions of the vehicle in the method provided in this embodiment of this application, the another device may be a cloud BMS. The communication interface 730 may be, for example, a transceiver, an interface, a bus, a circuit, or an apparatus that can implement receiving and sending functions. The processor 710 may send and receive data and/or information by using the communication interface 730, and is configured to implement the method performed by the cloud BMS or the vehicle (or the vehicle BMS) in the corresponding embodiment in FIG. 2.

A specific connection medium between the processor 710, the memory 720, and the communication interface 730 is not limited in this embodiment of this application. In this embodiment of this application, in FIG. 7, the processor 710, the memory 720, and the communication interface 730 are connected by using a bus 740. The bus 740 is represented by a thick line in FIG. 7, and connections between other components are merely examples for description, and shall not be construed as a limitation. The bus may be classified into an address bus, a data bus, a control bus, and the like. For ease of representation, only one thick line is used to represent the bus in FIG. 7, but this does not mean that there is only one bus or only one type of bus.

This application provides a cloud BMS. The cloud BMS includes a memory and a processor. The memory is configured to store program code. The processor is configured to invoke the program code to implement the method performed by the cloud BMS in the embodiment shown in FIG. 2.

This application provides a vehicle BMS. The vehicle BMS includes a memory and a processor. The memory is configured to store program code. The processor is configured to invoke the program code to implement the method performed by the vehicle (or the vehicle BMS) in the embodiment shown in FIG. 2.

This application provides a vehicle. The vehicle includes a memory and a processor. The memory is configured to store program code. The processor is configured to invoke the program code to implement the method performed by the vehicle in the embodiment shown in FIG. 2.

This application further provides a battery fault diagnosis system, including the foregoing cloud BMS and vehicle BMS.

This application further provides a battery fault diagnosis system, including the foregoing cloud BMS and vehicle.

This application further provides a chip system. The chip system includes at least one processor, configured to implement functions in the method performed by the cloud BMS or the vehicle in the embodiment shown in FIG. 2, for example, receive or process data and/or information in the foregoing method.

In a possible design, the chip system further includes a memory. The memory is configured to store a program instruction and data, and the memory is located inside or outside the processor.

The chip system may include a chip, or may include a chip and another discrete device.

This application further provides a computer-readable storage medium. The computer storage medium stores a computer program (which may also be referred to as code or instructions). When the computer program is run by a processor, the method performed by the cloud BMS or the vehicle (or the vehicle BMS) in the embodiment shown in FIG. 2 is performed.

This application further provides a computer program product. The computer program product includes a computer program (which may also be referred to as code or instructions). When the computer program is run, a computer is enabled to perform the method performed by the cloud BMS or the vehicle (or the vehicle BMS) in the embodiment shown in FIG. 2.

The processor in this embodiment of this application may be an integrated circuit chip, and has a signal processing capability. In an implementation process, steps in the foregoing method embodiments may be implemented by using a hardware integrated logic circuit in the processor, or by using instructions in a form of software. The processor may be a general purpose processor, a digital signal processor (DSP), an application specific integrated circuit (ASIC), a field programmable gate array (FPGA) or another programmable logic device, a discrete gate or transistor logic device, or a discrete hardware component. The processor may implement or perform the methods, steps, and logical block diagrams that are disclosed in this embodiment of this application. The general purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in the decoding processor and a software module. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor.

The memory in embodiments of this application may be a volatile memory or a non-volatile memory, or may include a volatile memory and a non-volatile memory. The non-volatile memory may be a read-only memory (ROM), a programmable read-only memory (PROM), an erasable programmable read-only memory (EPROM), an electrically erasable programmable read-only memory (EEPROM), or a flash memory. The volatile memory may be a random access memory (RAM). By way of example and not limitation, RAMs in many forms may be used, for example, a static random access memory (SRAM), a dynamic random access memory (DRAM), a synchronous dynamic random access memory (SDRAM), a double data rate synchronous dynamic random access memory (DDR SDRAM), an enhanced synchronous dynamic random access memory (ESDRAM), a synchlink dynamic random access memory (SLDRAM), and a direct rambus random access memory (DR RAM). It should be noted that the memory of the systems and methods described in this specification includes but is not limited to these and any other proper types of memories.

Terms such as "unit" and "module" used in this specification are used to indicate computer-related entities, hardware, firmware, combinations of hardware and software, software, or software being executed.

A person of ordinary skill in the art may be aware that, in combination with illustrative logical blocks (illustrative logical block) described in embodiments disclosed in this specification and steps (step) may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application. In the several embodiments provided in this application, it should be understood that the disclosed apparatus, device and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be indirect couplings or communication connections through some interfaces, apparatuses or units, and may be implemented in electrical, mechanical, or other forms.

The units described as separate parts may or may not be physically separate, and parts displayed as units may or may not be physical units, may be located in one position, or may be distributed on a plurality of network elements. In addition, functional units in the embodiments of this application may be integrated into one processing unit, or each of the units may exist alone physically, or two or more units are integrated into one unit.

In the foregoing embodiments, all or some of the functions of the functional units may be implemented by software, hardware, firmware, or any combination thereof. When software is used to implement the embodiments, all or a part of the embodiments may be implemented in a form of a computer program product. The computer program product includes one or more computer instructions (programs). When the computer program instructions (programs) are loaded and executed on a computer, the procedures or functions according to embodiments of this application are all or partially generated. The computer may be a general-purpose computer, a special-purpose computer, a computer network, or other programmable apparatuses. The computer instructions may be stored in a computer-readable storage medium or may be sent from a computer-readable storage medium to another computer-readable storage medium. For example, the computer instructions may be sent from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a digital video disc (DVD)), a semiconductor medium (for example, a solid state disk (SSD)), or the like.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in embodiments of this application. The foregoing storage medium includes any medium that may store program code, such as a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A battery fault diagnosis method, comprising:
receiving (210) a first original data set from a vehicle, wherein the first original data set is obtained from the vehicle through collection;
preliminarily diagnosing (220) a battery of the vehicle based on the first original data set, and sending a risk warning to the vehicle based on the preliminary diagnosis for the battery; and
receiving data from the vehicle, wherein the data comprises: a second original data set or first diagnostic data obtained by the vehicle based on the second original data set, the second original data set is obtained from the vehicle through collection, the second original data set is used to deeply diagnose the battery, and data items comprised in the second original data set are more than data items comprised in the first original data set and a data collection frequency of the second original data set is higher than a data collection frequency of the first original data set.

2. The method according to claim 1, wherein the method further comprises:
deeply diagnosing (240) the battery based on the second original data set, to determine a fault level of the battery.

3. The method according to claim 1, wherein the method further comprises:
deeply diagnosing (240) the battery based on the second original data set and the first diagnostic data, to determine a fault level of the battery.

4. The method according to claim 1, wherein the first diagnostic data comprises a fault level of the battery.

5. The method according to any one of claims 1 to 4, wherein the sending a risk warning to the vehicle based on the preliminary diagnosis for the battery comprises:
determining a diagnostic result based on the preliminary diagnosis for the battery, wherein the diagnostic result comprises a state of health of the battery or a fault probability value of the battery; and
sending the risk warning to the vehicle when the diagnostic result reaches a preset threshold.

6. The method according to claim 5, wherein when the diagnostic result reaches the preset threshold, the method further comprises:
sending an over-the-air technology OTA upgrade package to the vehicle, wherein the OTA upgrade package is used for an OTA upgrade of the vehicle.

7. The method according to claim 6, wherein the OTA upgrade package comprises a charge/discharge adjustment policy, and the charge/discharge adjustment policy is used to adjust a maximum degree of charge and/or a maximum depth of discharge of the battery.

8. The method according to any one of claims 1 to 7, wherein the risk warning indicates a risk level of the battery and/or a fault type of the battery, the risk level is used to determine a degree of emergency of the deep diagnosis, different risk levels correspond to different degrees of emergency, and the fault type comprises one or more of the following: thermal runaway, internal short circuit, poor consistency, overtemperature, undervoltage, or overvoltage.

9. A battery fault diagnosis method, comprising:
uploading (210) a first original data set obtained from a vehicle through collection to a cloud battery management system BMS, wherein the first original data set is used to preliminarily diagnose a battery of the vehicle;
when a risk warning from the cloud BMS is received, obtaining (230) a second original data set, wherein the second original data set is used to deeply diagnose the battery, wherein the risk warning is sent based on the preliminary diagnosis for the battery, the second original data set is obtained from the vehicle through collection, and data items comprised in the second original data set are more than data items comprised in the first original data set and a data collection frequency of the second original data set is higher than a data collection frequency of the first original data set; and
sending data to the cloud BMS, wherein the data comprises: data in the second original data set, or first diagnostic data obtained by the vehicle based on the second original data set.

10. The method according to claim 9, wherein the first diagnostic data comprises a fault level of the battery, and the fault level is obtained by the vehicle through deep diagnosis performed by the vehicle based on the second original data set.

11. The method according to claim 9, wherein the sending data to the cloud BMS comprises:
sending the second original data set and the first diagnostic data to the cloud BMS, wherein the second original data set and the first diagnostic data are used by the cloud BMS to deeply diagnose the battery, to determine a fault level of the battery.

12. The method according to claim 9, wherein the sending data to the cloud BMS comprises:
uploading the second original data set to the cloud BMS, wherein the second original data set is used by the cloud BMS to deeply diagnose the battery, to determine a fault level of the battery.

13. The method according to any one of claims 9 to 12, wherein the risk warning indicates a risk level of the battery and/or a fault type of the battery, the risk level is used to determine a degree of emergency of the deep diagnosis, different risk levels correspond to different degrees of emergency, and the fault type comprises one or more of the following: thermal runaway, internal short circuit, poor consistency, overtemperature, undervoltage, or overvoltage.

14. A cloud battery management system BMS (700), comprising a memory (720) and a processor (710), wherein
the memory (720) is configured to store program code; and
the processor (710) is configured to invoke the program code to implement the method according to any one of claims 1 to 8.

15. A vehicle battery management system BMS (700), comprising a memory (720) and a processor (710), wherein
the memory (720) is configured to store program code; and
the processor (710) is configured to invoke the program code to implement the method according to any one of claims 9 to 13.

## Patentansprüche

1. Verfahren zur Batteriefehlerdiagnose, umfassend:
Empfangen (210) eines ersten Originaldatensatzes aus einem Fahrzeug, wobei der erste Originaldatensatz aus dem Fahrzeug per Erfassung erlangt wird;
vorläufiges Diagnostizieren (220) einer Batterie des Fahrzeugs basierend auf dem ersten Originaldatensatz und Senden einer Risikowarnung an das Fahrzeug basierend auf der vorläufigen Diagnose für die Batterie; und
Empfangen von Daten aus dem Fahrzeug, wobei die Daten Folgendes umfassen: einen zweiten Originaldatensatz oder erste Diagnosedaten, die durch das Fahrzeug basierend auf dem zweiten Originaldatensatz erlangt werden, wobei der zweite Originaldatensatz aus dem Fahrzeug per Erfassung erlangt wird, der zweite Originaldatensatz verwendet wird, um eine Tiefendiagnose der Batterie durchzuführen, und Datenelemente, die in dem zweiten Originaldatensatz enthalten sind, mehr als Datenelemente sind, die in dem ersten Originaldatensatz enthalten sind, und eine Datenerfassungsfrequenz des zweiten Originaldatensatzes höher als eine Datenerfassungsfrequenz des ersten Originaldatensatzes ist.

2. Verfahren nach Anspruch 1, wobei das Verfahren ferner Folgendes umfasst:
Durchführen einer Tiefendiagnose (240) der Batterie basierend auf dem zweiten Originaldatensatz, um einen Fehlerstand der Batterie zu bestimmen.

3. Verfahren nach Anspruch 1, wobei das Verfahren ferner Folgendes umfasst:
Durchführen einer Tiefendiagnose (240) der Batterie basierend auf dem zweiten Originaldatensatz und den ersten Diagnosedaten, um einen Fehlerstand der Batterie zu bestimmen.

4. Verfahren nach Anspruch 1, wobei die ersten Diagnosedaten einen Fehlerstand der Batterie umfassen.

5. Verfahren nach einem der Ansprüche 1 bis 4, wobei das Senden einer Risikowarnung an das Fahrzeug basierend auf der vorläufigen Diagnose für die Batterie Folgendes umfasst:
Bestimmen eines Diagnoseergebnisses basierend auf der vorläufigen Diagnose für die Batterie, wobei das Diagnoseergebnis einen Gesundheitszustand der Batterie oder einen Fehlerwahrscheinlichkeitswert der Batterie umfasst; und
Senden der Risikowarnung an das Fahrzeug, wenn das Diagnoseergebnis einen vorgegebenen Schwellenwert erreicht.

6. Verfahren nach Anspruch 5, wobei das Verfahren, wenn das Diagnoseergebnis den vorgegebenen Schwellenwert erreicht, ferner Folgendes umfasst:
Senden eines Over-the-Air-Technology-Upgrade-Pakets, OTA-Upgrade-Paket, an das Fahrzeug, wobei das OTA-Upgrade-Paket für ein OTA-Upgrade des Fahrzeugs verwendet wird.

7. Verfahren nach Anspruch 6, wobei das OTA-Upgrade-Paket eine Lade-/Entlade-Anpassungsrichtlinie umfasst und die Lade-/Entlade-Anpassungsrichtlinie verwendet wird, um einen maximalen Ladegrad und/oder eine maximale Entladetiefe der Batterie anzupassen.

8. Verfahren nach einem der Ansprüche 1 bis 7, wobei die Risikowarnung ein Risikoniveau der Batterie und/oder einen Fehlertyp der Batterie anzeigt, das Risikoniveau verwendet wird, um einen Notfallgrad der Tiefendiagnose zu bestimmen, unterschiedliche Risikoniveaus unterschiedlichen Notfallgraden entsprechen und der Fehlertyp einen oder mehrere der folgenden Zustände umfasst: thermische Instabilität, interner Kurzschluss, schlechte Konsistenz, Übertemperatur, Unterspannung oder Überspannung.

9. Verfahren zur Batteriefehlerdiagnose, umfassend:
Hochladen (210) eines ersten Originaldatensatzes, der aus einem Fahrzeug per Erfassung erlangt wurde, in ein Cloud-Batterieverwaltungssystem BMS, wobei der erste Originaldatensatz verwendet wird, um eine Batterie des Fahrzeugs vorläufig zu diagnostizieren;
wenn eine Risikowarnung aus dem Cloud-BMS empfangen wird, Erlangen (230) eines zweiten Originaldatensatzes, wobei der zweite Originaldatensatz verwendet wird, um eine Tiefendiagnose der Batterie durchzuführen, wobei die Risikowarnung basierend auf der vorläufigen Diagnose für die Batterie gesendet wird, der zweite Originaldatensatz aus dem Fahrzeug per Erfassung erlangt wird und Datenelemente, die in dem zweiten Originaldatensatz enthalten sind, mehr als Datenelemente sind, die in dem ersten Originaldatensatz enthalten sind, und eine Datenerfassungsfrequenz des zweiten Originaldatensatzes höher als eine Datenerfassungsfrequenz des ersten Originaldatensatzes ist; und
Senden von Daten an das Cloud-BMS, wobei die Daten Folgendes umfassen: Daten in dem zweiten Originaldatensatz oder erste Diagnosedaten, die durch das Fahrzeug basierend auf dem zweiten Originaldatensatzes erlangt werden.

10. Verfahren nach Anspruch 9, wobei die ersten Diagnosedaten einen Fehlerstand der Batterie umfassen und der Fehlerstand durch das Fahrzeug per Tiefendiagnose, die durch das Fahrzeug basierend auf dem zweiten Originaldatensatz durchgeführt wird, erlangt wird.

11. Verfahren nach Anspruch 9, wobei das Senden von Daten an das Cloud-BMS Folgendes umfasst:
Senden des zweiten Originaldatensatzes und der ersten Diagnosedaten an das Cloud-BMS, wobei der zweite Originaldatensatz und die ersten Diagnosedaten durch das Cloud-BMS verwendet werden, um eine Tiefendiagnose der Batterie durchzuführen, um einen Fehlerstand der Batterie zu bestimmen.

12. Verfahren nach Anspruch 9, wobei das Senden von Daten an das Cloud-BMS Folgendes umfasst:
Hochladen des zweiten Originaldatensatzes in das Cloud-BMS, wobei der zweite Originaldatensatz durch das Cloud-BMS verwendet wird, um eine Tiefendiagnose der Batterie durchzuführen, um einen Fehlerstand der Batterie zu bestimmen.

13. Verfahren nach einem der Ansprüche 9 bis 12, wobei die Risikowarnung ein Risikoniveau der Batterie und/oder einen Fehlertyp der Batterie anzeigt, das Risikoniveau verwendet wird, um einen Notfallgrad der Tiefendiagnose zu bestimmen, unterschiedliche Risikoniveaus unterschiedlichen Notfallgraden entsprechen und der Fehlertyp einen oder mehrere der folgenden Zustände umfasst: thermische Instabilität, interner Kurzschluss, schlechte Konsistenz, Übertemperatur, Unterspannung oder Überspannung.

14. Cloud-Batterieverwaltungssystem BMS (700), umfassend einen Speicher (720) und einen Prozessor (710), wobei
der Speicher (720) dazu konfiguriert ist, Programmcode zu speichern; und
der Prozessor (710) dazu konfiguriert ist, den Programmcode aufzurufen, um das Verfahren nach einem der Ansprüche 1 bis 8 zu implementieren.

15. Fahrzeug-Batterieverwaltungssystem BMS (700), umfassend einen Speicher (720) und einen Prozessor (710), wobei
der Speicher (720) dazu konfiguriert ist, Programmcode zu speichern; und
der Prozessor (710) dazu konfiguriert ist, den Programmcode in dem Speicher aufzurufen, um das Verfahren nach einem der Ansprüche 9 bis 13 zu implementieren.

## Revendications

1. Procédé de diagnostic de défaillance de batterie, comprenant :
la réception (210) d'un premier ensemble de données d'origine provenant d'un véhicule, dans lequel le premier ensemble de données d'origine est obtenu à partir du véhicule par collecte ;
le diagnostic préliminaire (220) d'une batterie du véhicule sur la base du premier ensemble de données d'origine, et l'envoi d'un avertissement de risque au véhicule sur la base du diagnostic préliminaire de la batterie ; et
la réception de données provenant du véhicule, dans lequel les données comprennent : un second ensemble de données d'origine ou des premières données de diagnostic obtenues par le véhicule sur la base du second ensemble de données d'origine, le second ensemble de données d'origine est obtenu à partir du véhicule par collecte, le second ensemble de données d'origine est utilisé pour diagnostiquer en profondeur la batterie, et les éléments de données compris dans le second ensemble de données d'origine sont plus nombreux que les éléments de données compris dans le premier ensemble de données d'origine et une fréquence de collecte de données du second ensemble de données d'origine est supérieure à une fréquence de collecte de données du premier ensemble de données d'origine.

2. Procédé selon la revendication 1, dans lequel le procédé comprend également :
le diagnostic en profondeur (240) de la batterie sur la base du second ensemble de données d'origine, pour déterminer un niveau de défaillance de la batterie.

3. Procédé selon la revendication 1, dans lequel le procédé comprend également :
le diagnostic en profondeur (240) de la batterie sur la base du second ensemble de données d'origine et des premières données de diagnostic, pour déterminer un niveau de défaillance de la batterie.

4. Procédé selon la revendication 1, dans lequel les premières données de diagnostic comprennent un niveau de défaillance de la batterie.

5. Procédé selon l'une quelconque des revendications 1 à 4, dans lequel l'envoi d'un avertissement de risque au véhicule sur la base du diagnostic préliminaire de la batterie comprend :
la détermination d'un résultat de diagnostic sur la base du diagnostic préliminaire de la batterie, dans lequel le résultat de diagnostic comprend un état de santé de la batterie ou une valeur de probabilité de défaillance de la batterie ; et
l'envoi de l'avertissement de risque au véhicule lorsque le résultat de diagnostic atteint un seuil prédéfini.

6. Procédé selon la revendication 5, dans lequel lorsque le résultat de diagnostic atteint le seuil prédéfini, le procédé comprend également :
l'envoi d'un package de mise à niveau de technologie par voie aérienne OTA au véhicule, dans lequel le package de mise à niveau OTA est utilisé pour une mise à niveau OTA du véhicule.

7. Procédé selon la revendication 6, dans lequel le package de mise à niveau OTA comprend une politique de réglage de charge/décharge, et la politique de réglage de charge/décharge est utilisée pour régler un degré maximal de charge et/ou une profondeur maximale de décharge de la batterie.

8. Procédé selon l'une quelconque des revendications 1 à 7, dans lequel l'avertissement de risque indique un niveau de risque de la batterie et/ou un type de défaillance de la batterie, le niveau de risque est utilisé pour déterminer un degré d'urgence du diagnostic approfondi, différents niveaux de risque correspondent à différents degrés d'urgence, et le type de défaillance comprend un ou plusieurs des éléments suivants : emballement thermique, court-circuit interne, mauvaise cohérence, surchauffe, sous-tension ou surtension.

9. Procédé de diagnostic de défaillance de batterie, comprenant :
le téléchargement (210) d'un premier ensemble de données d'origine obtenu à partir d'un véhicule par collecte vers un système de gestion de batterie BMS cloud, dans lequel le premier ensemble de données d'origine est utilisé pour diagnostiquer de manière préliminaire une batterie du véhicule ;
lorsqu'un avertissement de risque provenant du BMS cloud est reçu, l'obtention (230) d'un second ensemble de données d'origine, dans lequel le second ensemble de données d'origine est utilisé pour diagnostiquer en profondeur la batterie, dans lequel l'avertissement de risque est envoyé sur la base du diagnostic préliminaire de la batterie, le second ensemble de données d'origine est obtenu à partir du véhicule par collecte, et les éléments de données compris dans le second ensemble de données d'origine sont plus nombreux que les éléments de données compris dans le premier ensemble de données d'origine et une fréquence de collecte de données du second ensemble de données d'origine est supérieure à une fréquence de collecte de données du premier ensemble de données d'origine ; et
l'envoi de données au BMS cloud, dans lequel les données comprennent : des données dans le second ensemble de données d'origine, ou des premières données de diagnostic obtenues par le véhicule sur la base du second ensemble de données d'origine.

10. Procédé selon la revendication 9, dans lequel les premières données de diagnostic comprennent un niveau de défaillance de la batterie, et le niveau de défaillance est obtenu par le véhicule par un diagnostic approfondi réalisé par le véhicule sur la base du second ensemble de données d'origine.

11. Procédé selon la revendication 9, dans lequel l'envoi de données au BMS cloud comprend :
l'envoi du second ensemble de données d'origine et des premières données de diagnostic au BMS cloud, dans lequel le second ensemble de données d'origine et les premières données de diagnostic sont utilisés par le BMS cloud pour diagnostiquer en profondeur la batterie, afin de déterminer un niveau de défaillance de la batterie.

12. Procédé selon la revendication 9, dans lequel l'envoi de données au BMS cloud comprend :
le téléchargement du second ensemble de données d'origine sur le BMS cloud, dans lequel le second ensemble de données d'origine est utilisé par le BMS cloud pour diagnostiquer en profondeur la batterie, afin de déterminer un niveau de défaillance de la batterie.

13. Procédé selon l'une quelconque des revendications 9 à 12, dans lequel l'avertissement de risque indique un niveau de risque de la batterie et/ou un type de défaillance de la batterie, le niveau de risque est utilisé pour déterminer un degré d'urgence du diagnostic approfondi, différents niveaux de risque correspondent à différents degrés d'urgence, et le type de défaillance comprend un ou plusieurs des éléments suivants : emballement thermique, court-circuit interne, mauvaise cohérence, surchauffe, sous-tension ou surtension.

14. Système de gestion de batterie BMS (700) cloud, comprenant une mémoire (720) et un processeur (710), dans lequel
la mémoire (720) est configurée pour stocker le code de programme ; et
le processeur (710) est configuré pour appeler le code de programme pour mettre en œuvre le procédé selon l'une quelconque des revendications 1 à 8.

15. Système de gestion de batterie BMS (700) de véhicule, comprenant une mémoire (720) et un processeur (710), dans lequel la mémoire (720) est configurée pour stocker un code de programme ; et
le processeur (710) est configuré pour appeler le code de programme pour mettre en œuvre le procédé selon l'une quelconque des revendications 9 à 13.
